(19) Europäisches Patentamt
European Patent Office
Office européen des brevets

(11) EP 2 297 276 B1

(12) # EUROPÄISCHE PATENTSCHRIFT

(45) Veröffentlichungstag und Bekanntmachung des Hinweises auf die Patenterteilung:
**05.09.2012 Patentblatt 2012/36**

(21) Anmeldenummer: **09776804.8**

(22) Anmeldetag: **23.06.2009**

(51) Int Cl.:
***C09K 11/06*** (2006.01)

(86) Internationale Anmeldenummer:
**PCT/EP2009/004498**

(87) Internationale Veröffentlichungsnummer:
**WO 2010/006681 (21.01.2010 Gazette 2010/03)**

(54) **KOMPLEXE ZUR VERWENDUNG IN OPTO-ELEKTRONISCHEN BAUTEILEN**

COMPLEXES FOR USE IN OPTOELECTRONIC COMPONENTS

COMPLEXES EN VUE D'UNE UTILISATION DANS DES COMPOSANTS OPTO-ÉLECTRONIQUES

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **17.07.2008 DE 102008033563**

(43) Veröffentlichungstag der Anmeldung:
**23.03.2011 Patentblatt 2011/12**

(73) Patentinhaber: **Merck Patent GmbH**
**64293 Darmstadt (DE)**

(72) Erfinder:
- **YERSIN, Hartmut**
  **93161 Sinzing (DE)**
- **MONKOWIUS, Uwe**
  **A-4020 Linz (AT)**

(56) Entgegenhaltungen:
**EP-A- 1 930 392**
**WO-A-2005/056712**
**WO-A-2005/118606**
**WO-A-2007/031185**
**DE-A1-102006 017 485**

- **D.R. STRIPLIN: "Excited States of Homo- and Heteronuclear-Bridged Bimetallic Complexes" JOURNAL OF PHYSICAL CHEMISTRY, Bd. 99, 1995, Seiten 7977-7984, XP002541560 USA in der Anmeldung erwähnt**
- **BAO-HUI XIA: "Metal-Metal Interactions in Dinuclear d8 Metal Cyanide Complexes" INORGANIC CHEMISTRY, Bd. 41, 2002, Seiten 3866-3875, XP002541561 USA in der Anmeldung erwähnt**
- **QING-JIANG PAN: "Spectroscopic Properties of mono- and binuclear platinum(II) alkynyl complexes with phosphine ligands: A theoretical study" INORGANICA CHIMICA ACTA, Bd. 359, 3. April 2006 (2006-04-03), Seiten 3306-3314, XP002543515 München**
- **W. PETZ: "Reaction of the Carbodiphosphorane Ph3P=C=PPh3 with Platinum(II) and -(0) Compounds" ORGANOMETALLICS, Bd. 24, 2005, Seiten 5038-5043, XP002541562 USA**
- **M. INGA: "the nature of low-lying excited states of bridged Rhodium (I) and Iridium (I) binuclear complexes" ORGANOMETALLICS, Bd. 5, 1. Februar 1986 (1986-02-01), Seiten 230-234, XP002543490 USA**
- **M. INGA: "Electronic States of Rhodium(I) Binuclear A-Frame Complexes" INORGANIC CHEMISTRY, Bd. 25, 1. April 1986 (1986-04-01), Seiten 1506-1508, XP002543491 USA**
- **PIERRE D. HARVEY: "Luminescence Properties of Organometallic/Coordination Oligomers and Polymers Containing Diphosphin and Diisocyanide Assembling Ligands: Comparison between Mononuclear Model Complexes and Polymers" MACROMOLECULAR SYMPOSIUM, Bd. 209, 2004, Seiten 81-95, XP002543492 Weinheim**
- **VINCENT M. MISKOWSKI: "Spectroscopic and Photophysics of Rh2(dimen)42+ (dimen = 1,8-Diisocyanatomethane)" INORGANIC CHEMISTRY, Bd. 33, 1. Juni 2004 (2004-06-01), Seiten 2799-2807, XP002543493 USA**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 297 276 B1

• JUSTIN J. STACE: "Rhodium Dimers with 2,2-Dimethyl-1,3-diisocyano and Bis (diphenylphosphino)methane Bridging Ligands" INORGANIC CHEMISTRY, Bd. 45, 28. September 2006 (2006-09-28), Seiten 9123-9131, XP002543494 USA

## Beschreibung

Die Erfindung betrifft zwei- und mehrkernige Metall-Komplexe, die dadurch gekennzeichnet sind, dass diese kleine Singulett-Triplett-Energie-Abstände aufweisen und den sogenannten Triplett-Harvesting-Effekt zeigen. Weiterhin betrifft die Erfindung die Verwendung dieser Komplexe in opto-elektronischen Bauteilen.

## Einleitung

Elektrolumineszierende Verbindungen stellen das Herzstück organischer Leuchtdioden (sog. OLEDs, organic light emitting diodes) dar. Diese Verbindungen werden im Allgemeinen entweder über Vakuumsublimation oder nasschemisch aufgebracht. Im nass-chemischen Verfahren sind die Verbindungen im Allgemeinen eingebettet in oder chemisch gebunden an polymere Materialien, die in der Regel so beschaffen sind, dass in ihnen geeignete Ladungsträger (Elektronen bzw. Löcher) erzeugt und transportiert werden können mit der Maßgabe, dass beim Zusammentreffen gegensätzlich geladener Ladungsträger Exzitonen gebildet werden, die ihre Überschussenergie auf die jeweilige elektrolumineszierende Verbindung übertragen. Diese elektrolumineszierende Verbindung kann daraufhin in einen bestimmten elektronischen Anregungszustand übergehen, der dann möglichst vollständig und unter weitgehender Vermeidung strahlungsloser Desaktivierungsprozesse durch Lichtemission in den zugehörigen Grundzustand umgewandelt wird.

Als elektronischer Anregungszustand, der auch durch Energieübertragung von einem geeigneten Vorläufer-Exziton gebildet werden kann, kommt, von wenigen Ausnahmen abgesehen, entweder ein Singulett- oder Triplett-Zustand in Betracht. Da beide Zustände aufgrund der Spinstatistik in der Regel im Verhältnis 1:3 besetzt werden, ergibt sich, dass bei einer Emission aus dem Singulett-Zustand, die als Fluoreszenz bezeichnet wird, nur maximal 25 % der erzeugten Exzitonen wieder zur Emission führen. Dagegen können bei einer Triplett-Emission, die als Phosphoreszenz bezeichnet wird, sämtliche Exzitonen ausgenutzt, umgewandelt und als Licht emittiert werden (Triplett-Harvesting), so dass in diesem Fall die Innere Quantenausbeute den Wert von 100 % erreichen kann, sofern der mit angeregte und energetisch über dem Triplett-Zustand liegende Singulett-Zustand vollständig in den Triplett-Zustand relaxiert (Intersystem Crossing) und strahlungslose Konkurrenzprozesse bedeutungslos bleiben. Somit sind Triplett-Emitter im Allgemeinen effizientere Elektro-Luminophore und besser geeignet, in einer organischen Leuchtdiode für eine hohe Lichtausbeute zu sorgen.

Im Stand der Technik sind elektronische Bauteile bekannt; z.B. die Patenanmeldung WO 2007/031185 A (MERCK PATENT GMBH [DE]; BUESING ARNE [DE]; FORTTE ROCCO [DE]; STOESSEL) 22. März 2007 (2007-03-22) offenbart OLEDs, OFETs, OSCs, LECs), die zweikernige Übergangsmetallkomplexe gemäß der Formel III enthalten (Ansprüche 2, 16).

Die bisher bekannten phosphoreszierenden Triplett-Emitter in OLEDs weisen allerdings einen Nachteil auf, der darin besteht, dass die Emissionslebensdauer, die im Bereich von Mikrosekunden liegt, relativ lang ist. Dadurch ergeben sich Nachteile, und zwar zeigen sich mit wachsenden Stromdichten durch die Besetzung eines Großteils oder aller Emittermoleküle Sättigungseffekte. In der Folge können weitere Ladungsträger-Ströme nicht mehr zur Besetzung der angeregten und emittierenden Zustände führen. Es resultieren dann nur unerwünschte ohmsche Verluste. Infolgedessen ergibt sich mit steigender Stromdichte ein deutlicher Effizienz-Abfall des OLED-Devices (sog. "roll-off" Verhalten). In ähnlich ungünstiger Weise wirken sich die Effekte der Triplett-Triplett-Annihilation und des Self-Quenchens aus (siehe dazu die Ref. [1]). Eine deutliche Reduktion der Emissionslebensdauer der Emittermoleküle könnte diese Prozesse der Abnahme der Effizienz stark abschwächen.

Überraschenderweise lässt sich ein Effekt ausnutzen, der zur drastischen Verkürzung der Emissionslebensdauer führt, wobei trotzdem die hohe Effizienz, die durch das Triplett-Harvesting ermöglicht wird, voll erreicht werden kann. Es handelt sich um das hier erstmals vorgeschlagene "Singulett-Harvesting"-Verfahren. Dieses ist in Figur 1 erläutert. Durch die bereits bekannten Effekte des Triplett-Harvesting [2] wird der $T_1$-Zustand besetzt, und es resultiert die übliche $T_1 \rightarrow S_0$ Phosphoreszenz, allerdings mit der ungünstig langen Emissionslebensdauer. Die erfindungsgemäß für eine Verwendung vorgeschlagenen Komplex-Verbindungen besitzen nun interessanterweise einen sehr kleinen energetischen Abstand $\Delta E$ zwischen dem Singulett $S_1$ und dem Triplett $T_1$. In diesem Falle kann bei Raumtemperatur eine sehr effiziente thermische Rückbesetzung aus dem zunächst sehr effizient besetzten $T_1$-Zustand in den $S_1$-Zustand erfolgen.

Dieser Vorgang wird durch die Boltzmann-Verteilung gemäß Gleichung (1) gesteuert. Damit ergibt sich für das Intensitätsverhältnis

$$Int(S_1 \rightarrow S_0) / Int(T_1 \rightarrow S_0) = k(S_1) / k(T_1) \exp(-\Delta E/k_BT) \qquad (1)$$

Hierin stellen $k_B$ die Boltzmann-Konstante und T die absolute Temperatur dar. $k(S_1) / k(T_1)$ ist das Ratenver-

hältnis der Übergangsprozesse aus dem Singulett $S_1$ relativ zu dem aus dem Triplett $T_1$ in den elektronischen Grundzustand $S_0$. Für die erfindungsgemäß zur Verwendung vorgeschlagenen Komplexe liegt dieses Verhältnis in der Größenordnung von $10^3$ und darüber.

Durch den beschriebenen Prozess der thermischen Rückbesetzung wird ein schneller Emissionskanal aus dem kurzlebigen $S_1$-Zustand geöffnet, und die Gesamtlebensdauer wird deutlich reduziert. Diese Reduktion ist umso ausgeprägter, je kleiner die Energiedifferenz $\Delta E$ ist. Anhand eines Zahlenbeispiels soll das erläutert werden. Bei einer typischen Energiedifferenz von $\Delta E$ = 500 $cm^{-1}$ ergibt sich für Raumtemperaturanwendungen (T = 300 K) mit $k_BT$ = 200 $cm^{-1}$ und einem Ratenverhältnis von 0,5 x $10^3$ $cm^{-1}$ ein Intensitätsverhältnis gemäß Gleichung (1) von ca. 40. Das heißt, die Singulett-Emission ist in diesem typischen Beispiel vierzig-fach intensiver als die Triplett-Emission. Es liegt also ein Singulett-Harvesting-Effekt vor.

Interessanterweise zeigen nun die erfindungsgemäß einzusetzenden Verbindungen diese sehr kleinen Energiedifferenzen $\Delta E$. Als Folge des Singulett-Harvesting-Effektes werden die Emissionslebensdauern stark verringert, und es werden Werte um bzw. sogar unter 100 ns erreicht. Im obigen Beispiel beträgt die erreichte Lebensdauer (bei Annahme einer Singulett-Lebensdauer von 2 ns) nur ca. 25 ns.

Die erfindungsgemäßen Komplexe zeigen einen $\Delta E$-Abstand zwischen 50 $cm^{-1}$ und 3000 $cm^{-1}$, bevorzugt zwischen 50 $cm^{-1}$ und 2000 $cm^{-1}$, besonders bevorzugt zwischen 50 $cm^{-1}$ und 1000 $cm^{-1}$, ganz besonders bevorzugt zwischen 50 $cm^{-1}$ und 500 $cm^{-1}$.

Die OLED-Devices werden nach den dem Stand der Technik entsprechenden Verfahren hergestellt (vergleiche [1]).

Ein anderes wichtiges Ziel ist die effiziente Umwandlung von Sonnenenergie in elektrische Energie. Die damit verbundenen Anforderungen an den Device-Aufbau ähneln in vielen Anforderungen denen zum Bau eines OLEDs. So ist in den OLEDs dafür Sorge zu tragen, dass Löcher, von der Anode kommend, und Elektronen, von der Kathode kommend, an den Metallkomplexen rekombinieren und Licht abgeben. Umgekehrt ist bei den organische Solarzellen (OSCs, organic solar cell bzw. OPV, organic photovoltaics), ausgehend von den durch Sonnenlicht angeregten Metallkomplexen darauf zu achten, dass keine erneute Lichtemission erfolgt, sondern dass Löcher und Elektronen entstehen und zur Anode bzw. Kathode wandern. Bei dem zur Entstehung des Photo-Stroms in einer organischen Solarzelle führenden Prozess, der sich aus mehreren "elementaren" Schritten zusammensetzt, wird zunächst ein Photon des eingestrahlten Lichts von einem Farbstoff-Molekül in der Absorptions-Schicht absorbiert. Damit wird das Farbstoffmolekül elektronisch angeregt. Da das Molekül im angeregten Zustand (Exziton) andere Redox-Eigenschaften aufweist als im Grundzustand, kommt es bei geeignet gewählten HOMO- und LUMO-Lagen der Lochleiter- und Elektronenleiterschicht relativ zu den HOMO-/LUMO-Lagen der Absorptionsschicht zu einer elektrischen Ladungstrennung innerhalb der Absorptions-Schicht oder an einer der Schichtgrenzen. Die dadurch entstandenen Elektronen und Löcher wandern durch die jeweilige Elektronen- bzw. Lochleitungs-Schicht in Richtung der Elektroden, wodurch eine elektrische Spannung an den Elektroden entsteht. Aus diesem Funktionsprinzip ergeben sich die Anforderungen an die im Device verwendeten Substanzen:

*i)* eine sehr hohe Absorption des Farbstoffs über das ganze sichtbare Spektralgebiet bis in den nahen-IR Bereich,
*ii)* relativ gute Loch- bzw. Elektronenleitfähigkeiten der dafür vorgesehenen Schichten,
*iii)* guter Exzitonentransport in der Absorptionsschicht,
*iv)* effektive und schnelle Exzitonendissoziation sowie Abtransport der Ladungsträger in der Absorptionsschicht oder an einer der Grenzschichten, um eine Loch-Elektron-Rekombination zu vermeiden.

Die im Stand der Technik beschriebenen Probleme bei der Herstellung effizienter OSCs ergeben sich im Wesentlichen aus den folgenden zwei Gründen:

*i)* Fehlen von Materialien mit hoher Lichtabsorption vom sichtbaren Spektralbereich bis in den nahen Infrarot-Spektralbereich und
*ii)* Fehlen von Materialien mit hohen Exzitonen-Diffusionslängen, die eine Wanderung der Exzitonen aus dem Inneren der lichtabsorbierenden Schicht hin zur z. B. Grenzfläche, an der die Trennung der Exzitonen stattfindet, gewährleisten.

Die Lichtabsorptionsstärke eines Materials bei einer gegebenen Wellenlänge $\lambda$ wird durch das Lambert-Beersche Gesetz gegeben:

$$-\log(I/I_0) = \varepsilon(\lambda)cd \qquad (2)$$

mit $I$ = Intensität des transmittierten Lichtes, $I_0$ = Intensität des einfallenden/eingestrahlten Lichtes, $c$ = Konzentration der absorbierenden Substanz und $d$ = Weglänge des Lichtes im Material und ε(λ)= molarer dekadischer Extinktionskoeffizient.

Unter der Annahme, dass 99 % des einfallenden Lichtes absorbiert werden, d. h. $I/I_0$ = 0.01 bzw. -log($I/I_0$) = 2 und der Vernachlässigung von Reflexionen sowie einem Wert von $c$ = 5 mol/l (typische Feststoffkonzentrationen von Metallkomplexen, die Gegenstand der vorliegenden Erfindung sind) und $d$ = 100 nm (Dicke der Lichtabsorptionsschicht in einer OSC), lassen sich die erforderlichen molaren Extinktionskoeffizienten in Höhe von mindestens $10^4$ l $mol^{-1}cm^{-1}$ bis $10^5$ $mol^{-1}cm^{-1}$ abschätzen.

Typischerweise betragen jedoch die ε(λ) Werte für die bisher als OSC-Materialien verwendeten Übergangsmetall-Komplexe nur $10^3$ l $mol^{-1}cm^{-1}$ bis $10^4$ l $mol^{-1}cm^{-1}$ (gemessen auf dem Maximum der im Sichtbaren liegenden Absorptionsbande).

OSC- bzw. OPV-Devices werden nach den dem Stand der Technik entsprechenden Verfahren hergestellt (vergleiche [3]).

**Beschreibung der Erfindung**

Demgemäss lag der vorliegenden Erfindung die Aufgabe zu Grunde, Stoffe, insbesondere Emitter-Substanzen für OLEDs oder Absorptionsfarbstoffe für OSCs bereitzustellen, mit denen die Nachteile des Standes der Technik überwunden werden können bzw. mit denen sich insbesondere OLEDs mit Emittern mit kurzer Emissionslebensdauer und OSCs mit hoher Absorption herstellen lassen.

Diese Aufgabe wird gelöst durch die Bereitstellung einer organischen elektronischen Vorrichtung enthaltend einen ein- oder mehrkernigen Metallkomplex, insbesondere einen Übergangsmetallkomplex, der einen kleinen ΔE-Abstand zwischen dem untersten Triplett-Zustand und dem darüber liegenden und über thermische Rückbesetzung aus dem Triplett besetzten Singulett-Zustand aufweist. Dabei bedeutet ein kleiner ΔE-Abstand einen Abstand zwischen 50 $cm^{-1}$ und 3000 $cm^{-1}$, bevorzugt zwischen 50 $cm^{-1}$ und 2000 $cm^{-1}$, besonders bevorzugt zwischen 50 $cm^{-1}$ und 1000 $cm^{-1}$, insbesondere zwischen 50 $cm^{-1}$ und 500 $cm^{-1}$.

Ein weiterer Gegenstand der vorliegenden Erfindung ist die Verwendung eines ein- oder mehrkernigen Metallkomplexes, insbesondere eines Übergangsmetallkomplexes, der einen kleinen ΔE-Abstand zwischen dem untersten Triplett-Zustand und dem darüber liegenden und über thermische Rückbesetzung aus dem Triplett besetzten Singulett-Zustand aufweist, in einer organischen elektronischen Vorrichtung. Dabei bedeutet ein kleiner ΔE-Abstand einen Abstand zwischen 50 $cm^{-1}$ und 3000 $cm^{-1}$, bevorzugt zwischen 50 $cm^{-1}$ und 2000 $cm^{-1}$, besonders bevorzugt zwischen 50 $cm^{-1}$ und 1000 $cm^{-1}$, insbesondere zwischen 50 $cm^{-1}$ und 500 $cm^{-1}$.

Für einen vorgegebenen Komplex lässt sich der Energieabstand ΔE unter Verwendung der oben angegebenen Gleichung (1) einfach bestimmen. Eine Umformung ergibt:

$$\ln\{Int(S_1 \rightarrow S_0)/Int(T_1 \rightarrow S_0)\} = \ln\{k(S_1)/k(T_1)\} - (\Delta E/k_B)(1/T) \qquad (1a)$$

Für die Messung kann jedes handelsübliche Spektralphotometer verwendet werden. Eine graphische Auftragung der bei verschiedenen Temperaturen gemessenen (logarithmierten) Intensitätsverhältnisse $\ln\{Int(S_1 \rightarrow S_0)/Int(T_1 \rightarrow S_0)\}$ gegen den Kehrwert der absoluten Temperatur T ergibt in der Regel eine Gerade. Die Messung wird in einem Temperaturbereich von Raumtemperatur bis -78 °C durchgeführt, wobei die Temperatur mittels einem Kryostaten eingestellt wird. Die Intensitäten werden aus den (korrigierten) Spektren bestimmt, wobei $Int(S_1 \rightarrow S_0)$ bzw. $Int(T_1 \rightarrow S_0)$ die integrierten Fluoreszenz- bzw. Phosphoreszenz Bandenintensitäten repräsentieren, welche sich mittels der zum Spektralphotometer gehörenden Software bestimmen lassen. Diese lassen sich leicht identifizieren, da die Triplett-Bande bei niedrigeren Energien liegt als die Singulett-Bande und mit sinkender Temperatur an Intensität gewinnt. Dabei werden die Messungen in sauerstofffreien verdünnten Lösungen (ca. $10^{-5}$ mol $L^{-1}$) oder an dünnen Filmen (ca. 50 nm dick) des entsprechenden Moleküls durchgeführt. Verwendet man als Probe eine Lösung, so empfiehlt es sich, ein Lösemittel bzw. Lösemittelgemisch zu verwenden, das bei tiefen Temperaturen Gläser bildet, wie z. B. 2-Methyl-THF, THF oder aliphatische Kohlenwasserstoffe. Verwendet man als Probe einen Film, so eignet sich die Verwendung einer Matrix mit einer deutlich größeren Triplett-Energie, z. B. PMMA. Dieser Film kann aus Lösung aufgebracht werden. Die Geradensteigung beträgt $-\Delta E/k_B$. Mit $k_B$ = 1,380 $10^{-23}$ $JK^{-1}$ = 0,695 $cm^{-1}$ $K^1$ lässt sich der Energieabstand direkt bestimmen.

Dabei ist die organische elektronische Vorrichtung bevorzugt ausgewählt ist aus der Gruppe bestehend aus organischen Elektrolumineszenzvorrichtungen (organische lichtemittierende Dioden, OLEDs), lichtemittierenden elektrochemischen Zellen (light emitting electrochemical cells, LEECs), OLED-Sensoren, insbesondere nicht hermetisch nach außen abgeschirmte Gas- und Dampf-Sensoren, organischen Solarzellen (organic solar cells, OSCs; organic photovoltaics, OPVs), organischen Feldeffekttransistoren oder organischen Lasern.

Die erfindungsgemäß einzusetzenden Verbindungen sind einkernige oder mehrkernige Metallkomplexe. Bevorzugt werden mehrkernige Komplexe verwendet. Die mehrkernigen (bevorzugt zwei- oder z. B. dreikernigen) Metallkomplexe weisen eine M-M- bzw. M-M'- bzw. M-M-M- bzw. M-M'-M"-Wechselwirkung auf (M, M', M" sind Metallionenzentren). Dadurch resultieren elektronische Zustände mit den gewünschten, oben beschriebenen Eigenschaften, d. h. diese Komplexe weisen eine kleine Energiedifferenz $\Delta E$ auf und ermöglichen dadurch das Singulett-Harvesting und zeigen starke Absorptionen. Interessanterweise ergeben sich durch elektronische Wechselwirkungen zwischen den Metallen außerdem relativ hoch liegende HOMOs (highest occupied molecular orbitals [1]) sowie relativ tief liegende LUMOs (lowest unoccupied molecular orbitals [1]). Das hat besonders Vorteile für die Exzitonenbildung direkt auf den Emitter in der OLED-Anwendung [2] und hat günstige Eigenschaften als Absorber in OSCs.

**Zwei- und mehrkernige Übergangsmetallkomplexe**

Viele zwei- und mehrkernige Übergangsmetallkomplexe erfüllen die Anforderungen dieser Erfindung aufgrund der kleinen Metall(M)-Metall(M)-Abstände und der deutlichen M-M-Wechselwirkungen. Durch diese Wechselwirkungen entstehen elektronische Zustände, die zu intensiven Photoemissionen und kurzen Emissionslebensdauern gemäß dem Singulett-Harvesting-Effekt und hohen Emissionsquantenausbeuten führen können. Zusätzlich besitzen derartige Verbindungen im Allgemeinen hohe Extinktionskoeffizienten.

Besonders geeignet für derartige Komplexe sind Metalle mit einer $d^8$-Elektronenkonfiguration (Rh(I), Ir(I), Pd (II), Pt(II) und Au(III)] sowie einer $d^{10}$-Elektronenkonfiguration [Au(I)]. $d^8$-Metallzentren bevorzugen eine quadratisch-planare Koordination, während Au(I)-Atome meist linear koordiniert sind. Bei den $d^8$-Systemen resultieren die Bindungen durch die Überlappung eines besetzten d-Orbitals des einen Übergangsmetalls mit einem besetzten d-Orbital des zweiten Übergangsmetalls und gleichermaßen durch Überlappung der unbesetzten p-Orbitale entlang der M-M-Bindungsachse. Derartige Metall-Metall-Bindungen in mehrkernigen Übergangsmetallkomplexen werden meist durch besondere Ligandensysteme stabilisiert bzw. erst ermöglicht. Bei zweikernigen Komplexen kommen im Wesentlichen zweizähnige Ligandensysteme zum Einsatz, die eine kurze Brückenfunktion aufweisen. Anders als bei üblichen, bisher verwendeten Emitterkomplexen ist es hierbei nicht notwendig, dass die Liganden niedrig liegende elektronische Zustände besitzen. In vielen Fällen - insbesondere zur Erzeugung blauer Emission - kann es sogar vorteilhaft sein, wenn die Elektronenzustände der Liganden sehr hoch liegen und somit nicht mit den niedriger liegenden Zuständen interagieren, die aus den Metall-Metall-Wechselwirkungen resultieren. Die überbrückenden Liganden können entweder neutral oder ein- oder zweifach negativ geladen sein.

**A. Liganden L1-L9**

Unter Ligand L sollen in diesem Zusammenhang Liganden verstanden werden, die nicht überbrückend wirken und daher keinen direkten Einfluss auf die Dimerisierung nehmen. Wenngleich sie nicht strukturbildend sind, können sie einen großen Einfluss auf die M-M-Abstände nehmen, indem sie die Elektronendichten an den Metallen erhöhen oder erniedrigen. Wichtig sind die Liganden für die Absättigung der Koordinationssphäre des Metalls oder für den Ladungsausgleich oder für beides. Daher können diese Liganden L neutral oder anionisch sein. Weiterhin können die Liganden L monodentat oder bidentat sein. Die Liganden L sollen im Weiteren mit L1, L2, L3, L4, L5, L6, L7, L8 und L9 bezeichnet werden. Diese Liganden L müssen nicht und in Fällen zur Erzeugung blauer Emission dürfen nicht - ebenso wie die mehrzähnigen, überbrückenden Liganden - tiefliegende elektronische Zustände besitzen.

Geeignete neutrale, monodentate Liganden L sind ausgewählt aus Kohlenmonoxid, Stickstoffmonoxid, Nitrilen (RCN), Isonitrilen (RNC), wie z. B. *tert*-Butyl-isonitril, Cyclohexylisonitril, Adamantylisonitril, Phenylisonitril, Mesitylisonitril, 2,6-Dimethylphenylisonitril, 2,6-Di-*iso*-propylphenylisonitril, 2,6-Di-*tert*-butylphenylisonitril, Ethern (ROR'), wie z. B. Dimethylether, Diethylether, Sulfiden (RSR'), Seleniden (RSeR'), Aminen ($NR_3$), wie z. B. Trimethylamin, Triethylamin, Morpholin, Imine (RN=CR'), Phosphinen, wie z. B. Trifluorphosphin, Trimethylphosphin, Tricyclohexylphosphin, Tri-*tert*-butylphosphin, Triphenylphosphin, Tris(pentafluorphenyl)phosphin, Phosphiten, wie z. B. Trimethylphosphit, Triethylphosphit, Arsinen, wie z. B. Trifluorarsin, Trimethylarsin, Tricyclohexylarsin, Tri-*tert*-butylarsin, Triphenylarsin, Tris(pentafluorphenyl)arsin, Stibinen, wie z. B. Trifluorstibin, Trimethylstibin, Tricyclohexylstibin, Tri-*tert*-butylstibin, Triphenylstibin, Tris(pentafluorphenyl)stibin, und stickstoffhaltigen Heterocyclen, wie z. B. Pyridin, Pyridazin, Pyrazin, Pyrimidin, Triazin. R und R' kann dabei jeweils unabhängig voneinander Wasserstoff oder Halogen sein oder Substituenten, die über Sauerstoff (-OR"), Stickstoff ($-NR''_2$) oder Silizium ($-SiR''_3$), wobei R" identisch zu R definiert ist gebunden sind, sowie Alkyl-, Aryl-, Heteroaryl- und Alkenyl-Gruppen bzw. substituierte Alkyl-, Aryl-, Heteroaryl- und Alkenyl-Gruppen mit Substituenten wie Halogene, niedrige Alkylgruppen und weitere allgemein bekannte Donor- und Akzeptor-Gruppen. Die Gruppen R, R' und R" können auch zu annellierten Ringsystemen führen.

Geeignete monoanionische, monodentate Liganden L sind ausgewählt aus Hydrid, Deuterid, den Halogeniden F, Cl, Br und I, Azid, Alkylacetyliden, wie z. B. Methyl-$C\equiv C^-$, tert-Butyl-$C\equiv C^-$, Aryl- bzw. Heteroarylacetyliden, wie z. B. Phenyl-$C\equiv C^-$, Alkyl, wie z. B. Methyl, Ethyl, *n*-Propyl, *i*-Propyl, *n*-Butyl, *s*-Butyl, *t*-Butyl, Aryl, wie z. B. Phenyl, Naphthyl,

Heteroaryl, wie z. B. Pyridyl, Hydroxid, Cyanid, Cyanat, Isocyanat, Thiocyanat, Isothiocyanat, aliphatischen oder aromatischen Alkoholaten, wie z. B. Methanolat, Ethanolat, Propanolat, *iso*-Propanolat, *tert*-Butylat, Phenolat, aliphatischen oder aromatischen Thioalkoholaten, wie z. B. Methanthiolat, Ethanthiolat, Propanthiolat, *iso*-Propanthiolat, *tert*-Thiobutylat, Thiophenolat, Amiden, wie z. B. Dimethylamid, Diethylamid, Di-*iso*-propylamid, Morpholid, Carboxylaten, wie z. B. Acetat, Trifluoracetat, Propionat, Benzoat, anionischen, stickstoffhaltigen Heterocyclen, wie z. B. Pyrrolid, Imidazolid, Pyrazolid, aliphatischen und aromatischen Phosphiden $PR_2^-$ oder aliphatischen oder aromatischen Seleniden $SeR^-$. Dabei sind die Alkylgruppen in diesen Gruppen bevorzugt $C_1$-$C_{20}$-Alkylgruppen, besonders bevorzugt $C_1$-$C_{10}$-Alkylgruppen, ganz besonders bevorzugt $C_1$-$C_4$-Alkylgruppen. Unter einer Arylgruppe werden auch Heteroarylgruppen verstanden. Diese Gruppen sind wie oben definiert.

Geeignete di- bzw. trianionische Liganden $L^1$ sind $O^{2-}$, $S^{2-}$, Nitrene, welche zu einer Koordination der Form R-N=M führen, wobei R allgemein für einen Substituenten steht, oder $N^{3-}$.

Geeignete neutrale oder mono- oder dianionische bidentate Liganden sind ausgewählt aus Diaminen, wie z. B. Ethylendiamin, N,N,N',N'-Tetramethylethylendiamin, Propylendiamin, N,N,N',N'-Tetramethylpropylendiamin, cis- oder trans-Diaminocyclohexan, cis- oder trans-N,N,N',N'-Tetramethyldiaminocyclohexan, Iminen, wie z. B. 2-[1-(Phenylimino)ethyl]-pyridin, 2-[1-(2-Methylphenylimino)ethyl]pyridin, 2-[1-(2,6-Di-*iso*-propylphenylimino)ethyl]pyridin, 2-[1-(Methylimino)ethyl]pyridin, 2-[1-(Ethylimino)ethyl]pyridin, 2-[1-(*iso*-Propylimino)ethyl]pyridin, 2-[1-(*tert*-Butylimino) ethyl]pyridin, Diiminen, wie z. B. 1,2-Bis(methylimino)ethan, 1,2-Bis-(ethylimino)ethan, 1,2-Bis(*iso*-propylimino)ethan, 1,2-Bis(*tert*-butyliminor ethan, 2,3-Bis(methylimino)butan, 2,3-Bis(ethylimino)butan, 2,3-Bis(*iso*-propylimino)butan, 2,3-Bis(*tert*-butylimino)butan, 1,2-Bis(phenylimino)-ethan, 1,2-Bis(2-methylphenylimino)ethan, 1,2-Bis(2,6-di-*iso*-propylphenylimino)ethan, 1,2-Bis(2,6-di-*tert*-butylphenylimino)ethan, 2,3-Bis(phenylimino)butan, 2,3-Bis(2-methylphenylimino)butan, 2,3-Bis(2,6-di-*iso*-propylphenylimino)butan, 2,3-Bis(2,6-di-*tert*-butylphenylimino)butan, Heterocyclen enthaltend zwei Stickstoffatome, wie z. B. 2,2'-Bipyridin, o-Phenanthrolin, Diphosphinen, wie z. B. Bis(diphenylphosphino) methan, Bis(diphenylphosphino)ethan, Bis(diphenylphosphino)propan, Bis(diphenylphosphino)butan, Bis(dimethylphosphino)methan, Bis(dimethylphosphino)ethan, Bis(dimethylphosphino)propan, Bis(dimethylphosphino)-butan, Bis (diethylphosphino)methan, Bis(diethylphosphino)ethan, Bis(diethylphosphino)propan, Bis(diethylphosphino)butan, Bis (di-*tert*-butylphosphino)methan, Bis(di-*tert*-butylphosphino)ethan, Bis(*tert*-butylphosphino)-propan, Bis(*tert*-butyiphosphino)butan, 1,3-Diketonaten abgeleitet von 1,3-Diketonen, wie z. B. Acetylaceton, Benzoylaceton, 1,5-Diphenylacetylaceton, Dibenzoylmethan, Bis(1,1,1-tri-fluoracetyl)methan, 3-Ketonaten abgeleitet von 3-Ketoestern, wie z. B. Acetessigsäureethylester, Carboxylate, abgeleitet von Aminocarbonsäuren, wie z. B. Pyridin-2-carbonsäure, Chinolin-2-carbonsäure, Glycin, N,N-Dimethylglycin, Alanin, N,N-Dimethylaminoalanin, Salicyliminaten abgeleitet von Salicyliminen, wie z. B. Methylsalicylimin, Ethylsalicylimin, Phenylsalicylimin, Dialkoholaten abgeleitet von Dialkoholen, wie z. B. Ethylenglykol, 1,3-Propylenglykol und Dithiolaten abgeleitet von Dithiolen, wie z. B. 1,2-Ethylendithiol, 1,3-Propylendithiol.

Bevorzugt sind weiterhin bidentate monoanionische Liganden , welche mit dem Metall einen cyclometallierten Fünfring oder Sechsring mit mindestens einer Metall-Kohlenstoff-Bindung aufweisen, insbesondere einen cyclometallierten Fünfring. Dies sind insbesondere Liganden, wie sie allgemein auf dem Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils substituiert oder unsubstituiert sein können. Dem Fachmann auf dem Gebiet der phosphoreszierenden Elektrolumineszenzvorrichtungen ist eine Vielzahl derartiger Liganden bekannt, und er kann ohne erfinderisches Zutun weitere derartige Liganden als Ligand L für die zwei- oder mehrkernigen Metallkomplexe auswählen. Generell eignet sich dafür besonders die Kombination aus zwei Gruppen, wie sie durch die folgenden Formeln dargestellt sind. Der Ligand L kann dann aus diesen Gruppen gebildet werden, indem diese Gruppen jeweils an der durch # gekennzeichneten Position aneinander binden. Die Position, an der die Gruppen an das Metall koordinieren, sind durch * gekennzeichnet.

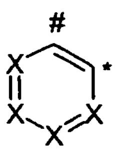 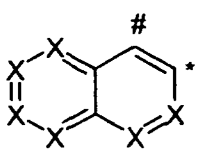 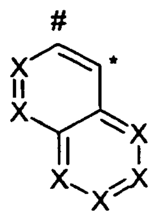 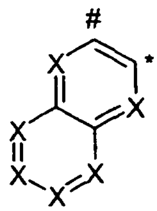

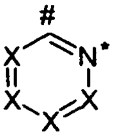
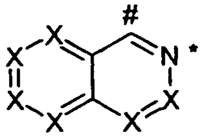
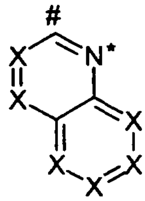
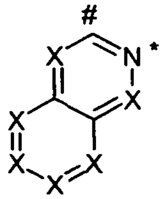

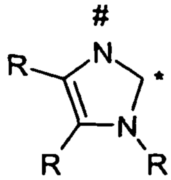
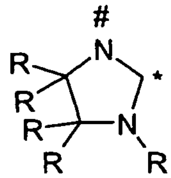
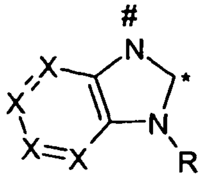
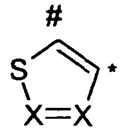

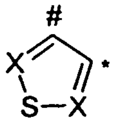
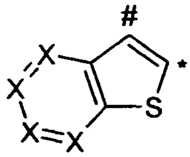
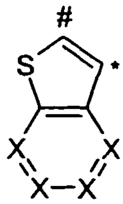
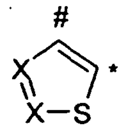

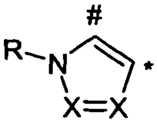
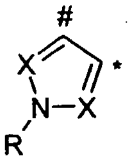
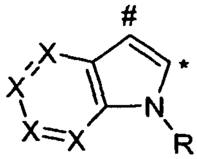
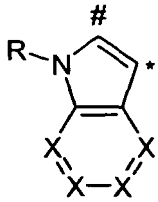

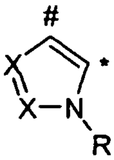
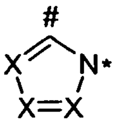
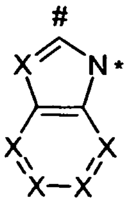
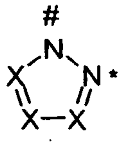

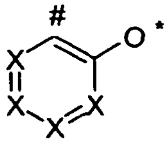
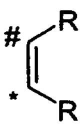
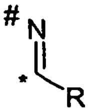
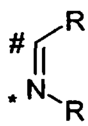

Dabei hat R die dieselbe Bedeutung, wie oben beschrieben, und X steht gleich oder verschieden bei jedem Auftreten für CR oder N mit der Maßgabe, dass maximal drei Symbole X in jeder Gruppe für N stehen. Bevorzugt stehen maximal zwei Symbole X in jeder Gruppe für N, besonders bevorzugt steht maximal ein Symbol X in jeder Gruppe für N, ganz besonders bevorzugt stehen alle Symbole X für CR.

**B. Zweikernige Metallkomplexe**

**B.1 Überbrückende Liganden**

Die überbrückenden Liganden werden im Weiteren als D∩D bezeichnet, wobei es sich bei "∩" um eine Brücke handelt. Bei D handelt es sich um das Atom oder die Atomgruppe, die an das Metallatom bindet. Beide Donorgruppen

D können gleich oder verschieden sein. Dadurch können sich auch asymmetrische Liganden der Form D∩D' ergeben. Die negative Ladung kann auf unterschiedliche Weise eingeführt werden: Entweder die bindenden Atome oder die bindenden Atomgruppen sind geladen, oder die Brücke "∩" ist geladen. D∩D kann aber auch neutral sein. Bei der Brücke handelt es sich um Atome oder Atomgruppen, die die Donorgruppen D tragen. Dafür eignen sich beispielsweise Alkyl- oder Arylgruppen, die mit den Gruppen D derartig funktionalisiert sind, dass sie eine Überbrückung zulassen, d. h., dass die beiden Gruppen D derart orientiert oder orientierbar sind, dass sie in dieselbe Richtung weisen. Mit anderen Worten, die Brücke muss eine möglichst parallele Orientierung der freien Elektronenpaare der Donorgruppe D ermöglichen:

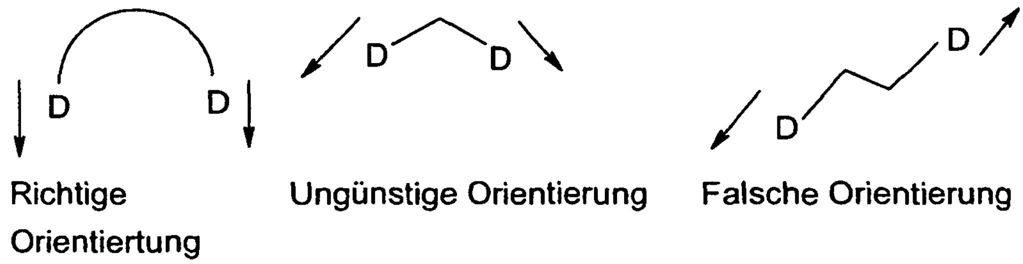


**Neutrale, überbrückende Liganden:**

Hier können die Donorgruppen D sein: $R_2N$-, $R_2P$-, $R_2As$-, $R_2N$-, CN-, NC-, RO-, RS-, RSe-, RN= ("-" oder "=" bezeichnet den Bindungsmodus, mit dem die Gruppe D an die Brücke gebunden ist).

In Betracht kommen folgende Ligandensysteme, bevorzugt mit einer kurzen Brücke "∩": $R_2E$-$CR_2$-$ER_2$; $R_2E$-$CR_2$-$CR_2$-$ER_2$; $R_2E$-NR-$ER_2$; $R_2E$-O-$ER_2$ mit E gleich oder verschieden bei jedem Auftreten N, P oder As; dabei hat R die oben genannte Bedeutung. Ebenso können Dinitrile und Diisonitrile NC∩CN und CN∩NC, Dialkohole HO∩OH, Diether RO∩OR, Dithiole HS∩SH, Dithioether RS∩SR, Diselenide HSe∩SeH und RSe∩SeR oder Kombinationen der Donorgruppen (D∩D') verwendet werden.

Die Brücke ist z. B. ∩ = $(CR_2)_n$ (n = 1-6) oder aromatische Systeme, die mit den Donorgruppen D funktionalisiert sind. Dabei ist die bevorzugte Brückenlänge n = 1, wenn das koordinierende Atom P oder As ist, und ist n = 2 oder 3 für andere koordinierende Atome.

Einige Beispiele für D∩D:

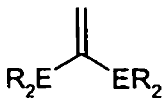 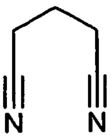 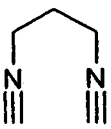 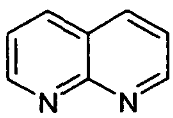 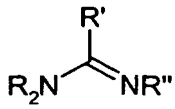

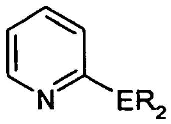 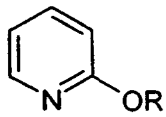 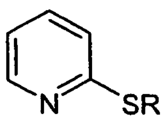 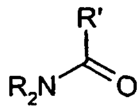

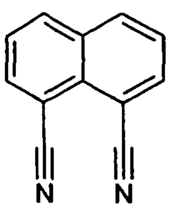 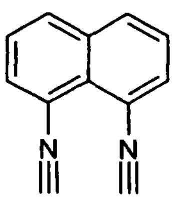

wobei E die oben genannte Bedeutung aufweist und R, R' und R" für einen beliebigen Substituenten, bevorzugt für eine Alkyl-, Aryl- oder Heteroarylgruppe stehen.

**Anionische, überbrückende Liganden:**

Hier sind eine oder beide Donorgruppen D negativ geladen, oder die Brücke "∩" trägt die Ladung. Häufig verwendete anionische Donorgruppen sind: $^{-}O-$, $^{-}S-$,$^{-}Se-$,$^{-}NR-$,$^{-}CH_2-$, $^{-}CH=$, $^{-}C\equiv C-$. Wieder können die beiden Donorgruppen D gleich (D∩D) oder verschieden (D∩D') sein.

**Beispiele:**

pop = $[P_2O_5H_2]^{2-}$;

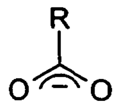
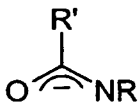
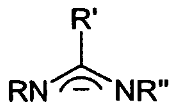
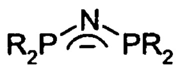
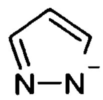

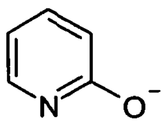
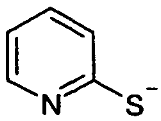
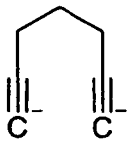
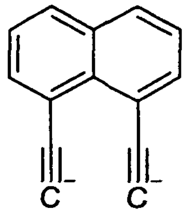
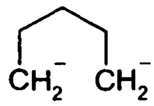

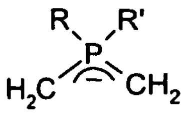
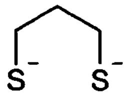
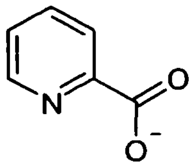
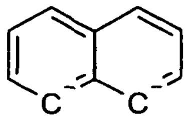

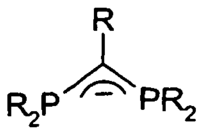
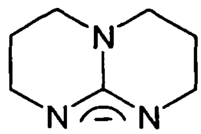

**B.2 Metallkomplexe**

Die Metallkomplexe besitzen die allgemeine Form **I-VIII:**

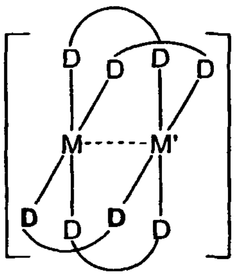

I

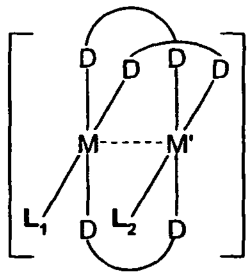

II

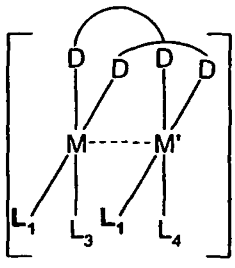

III

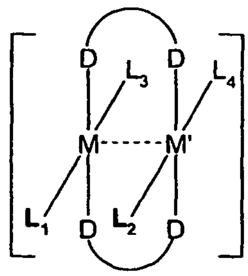

IV

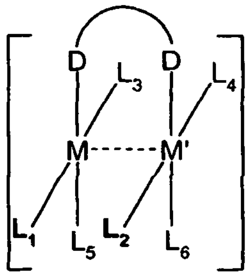

V

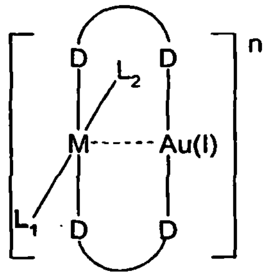

VI

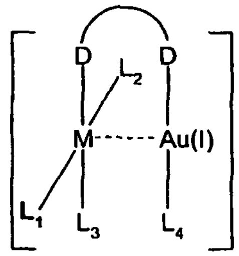

VII

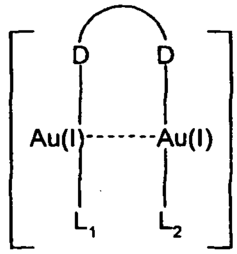

VIII

M und M' können Rh(I), Ir(I), Pd(II), Pt(II) oder Au(III) sein. Beide Metalle können entweder gleich (M = M') oder verschieden sein (M ≠ M'). Bevorzugt sind beide Metalle gleich. Der überbrückende Ligand D∩D kann entweder gleich sein, oder es können zwei oder mehrere unterschiedliche überbrückende Liganden im Komplex vorhanden sein. Ebenso können die Liganden L1-L6 gleich sein oder sich voneinander unterscheiden. Abhängig von der Wahl der Metallzentren und der Liganden können die Komplexe neutral oder positiv oder negativ geladen sein (n = -4, -3, -2, -1, 0, 1, 2, 3, 4, 5, 6). Bevorzugt sind Komplexe mit der Ladung n = 0.

In einer bevorzugten Ausführungsform der Erfindung sind Komplexe mit M = M' = Au(I) ausgenommen. In einer besonders bevorzugten Ausführungsform der Erfindung sind M und M' ungleich Au.

Folgende M-M-Bindungen sind erfindungsgemäß möglich:

| | | | | |
|---|---|---|---|---|
| Rh(I)-Rh(I) | Ir(I)-Ir(I) | Pd(II)-Pd(II) | Pt(II)-Pt(II) | Au(I)-Au(III) |
| Rh(I)-Ir(I) | Ir(I)-Pd(II) | Pd(II)-Pt(II) | Pt(II)-Au(I) | Au(I)-Au(I) |
| Rh(I)-Pd(II) | Ir(IrPt(II) | Pd(II)-Au(I) | Pt(II)-Au(III) | |
| Rh(I)-Pt(II) | Ir(I)-Au(I) | Pd(II)-Au(III) | | |
| Rh(I)-Au(I) | Ir(I)-Au(III) | | | |
| Rh(I)-Au(III) | | | | |

Einige in der Literatur beschriebene zweikernige Komplexe mit den entsprechenden, vorteilhaften photophysikalischen Eigenschaften sollen die Erfindung veranschaulichen [4, 5]:

| | |
|---|---|
| $[Au(I)Ir(I)Cl(CO)(\mu\text{-dppm})_2]PF_6$ | (dppm = $Ph_2PCH_2PPh_2$) |
| $[Au(I)Rh(I)(t\text{-BuNC})_2(\mu\text{-dppm})_2]PF_6$ | |
| $[Pt(II)(CN)_2Rh(I)(t\text{-BuNC})_2(\mu\text{-dppm})_2]PF_6$ | |
| $[Au(I)Pt(II)(CN)_2(\mu\text{-dppm})_2]PF_6$ | |
| $Pt(II)_2(CN)_4(\mu\text{-dppm})_2$ | |
| $K_4[Pt(II)_2pop_4]$ | (pop = $[P_2O_5H_2]^{2-}$) |
| $[Ir(I)Cl(CO)(\mu\text{-dppm})]_2$ | |
| $[Rh(I)_2(t\text{-BuNC})_4(\mu\text{-dppm})_2][PF_6]_2$ | |
| $[Rh(I)_2(bridge)_2][BPh_4]_2$ | (bridge = 1,3-diisocyanopropane) |

Die oben genannten Komplexe können Gegenstand verschiedener Ausführungsformen der Erfindung, insbesondere im Rahmen der Verwendung der genannten Komplexe in opto-elektronische Bauteilen sein.

## C. Dreikernige Metallkomplexe

### C.1 Liganden

Verwendet werden hier dreizähnige Liganden, die Metallzentren in einer Weise verbinden können, dass sie in einer Reihe angeordnet sind.

Der Ligand D∩D∩D trägt drei Donorgruppen D, die in Analogie zu B.1 Atome oder Atomgruppen darstellen, die an das Metallatom binden und durch zwei Bürcken "∩" verbunden sind. Wieder sind entweder die bindenden Atome oder die bindenden Atomgruppen geladen, oder die Brücke/n "∩" ist/sind geladen. Die Liganden können auch neutral sein. Die Brücke ist analog zu B.1 definiert. Im Liganden D∩D∩D können die Brücken "∩" gleich oder verschieden, ebenso können die Donorgruppen D gleich oder verschieden (Kombinationen: D∩D∩D', D∩D'∩D, D∩D'∩D") sein.

**Beispiele:**

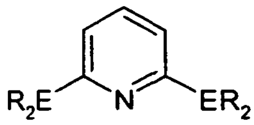
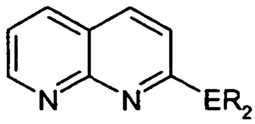
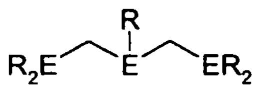

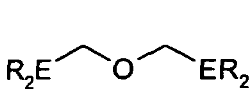
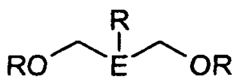

(E = N, P, As)

### C.2 Komplexe

Die Metallkomplexe besitzen die allgemeinen Formeln (IX) bis (XV):

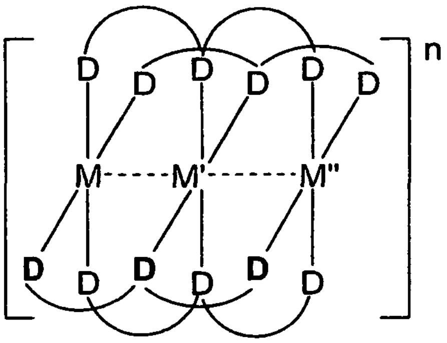

**IX**

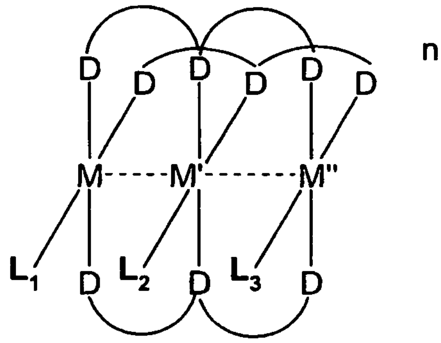

**X**

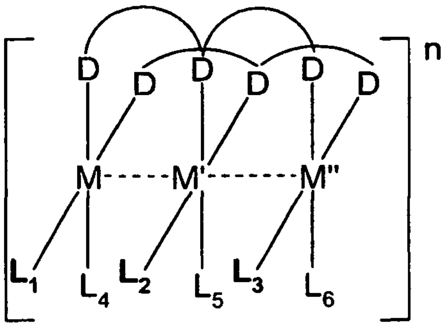

**XI**

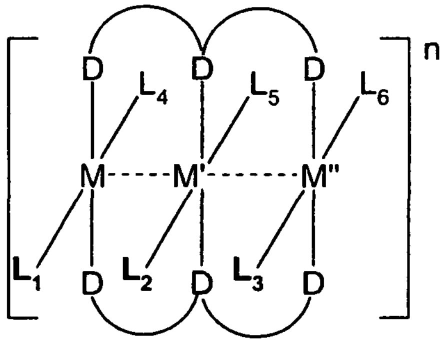

**XII**

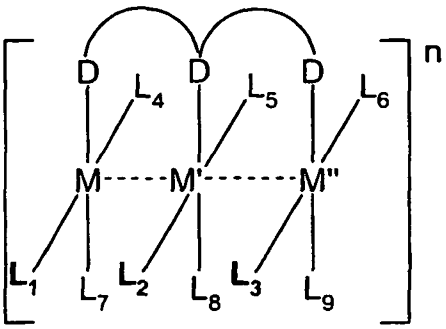

**XIII**

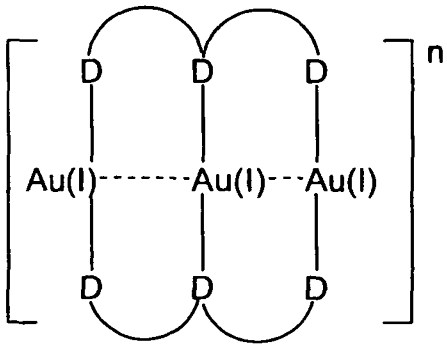

**XIV**

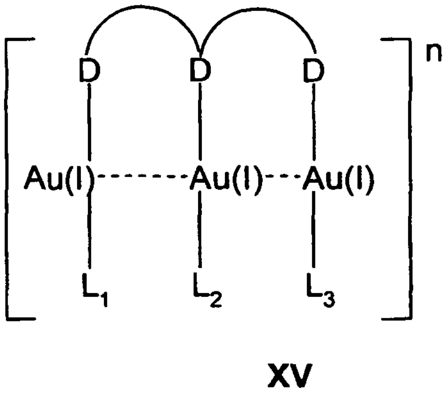

**XV**

M, M' und M" können Rh(I), Ir(I), Pd(II), Pt(II) oder Au(III) sein. Die Metalle können entweder gleich (M = M' = M") oder verschieden sein (M ≠ M' ≠ M"; M = M' ≠ M").

Die Liganden L1-L9 sind wieder definiert wie unter A und können entweder gleich oder unterschiedlich voneinander sein. Die Komplexe können neutral, kationisch oder anionisch sein (n = -3, -2, -1, 0, 1, 2, 3, 4, 5, 6, 7, 8, 9).

Bevorzugt sind Komplexe mit der Ladung n = 0.

Bevorzugt wird der Metallkomplex in einer Emitterschicht einer organischen Elektrolumineszenzvorrichtung eingesetzt, wobei die Konzentration des Komplexes in der Schicht bevorzugt 0.1 - 50 Vol.-%, besonders bevorzugt 1 bis 30 Vol.%, ganz besonders bevorzugt 2 Vol.-% bis 20 Vol.-% beträgt.

Weiterhin bevorzugt wird der Metallkomplex in einer Absorberschicht in einer organischen Solarzelle eingesetzt, wobei der Anteil des Komplexes in der Schicht bevorzugt 30 bis 100 Vol.-% beträgt.

Der Begriff "energetisch hochliegende Energiezustände" betrifft insbesondere Liganden, deren tiefste Triplettzustände über 25.000 $cm^{-1}$ liegen. Die Energie der Triplettzustände ergibt sich experimentell aus der Emissionskante (der größten Energie) des Phosphoreszenzspektrums.

Die Erfindung wird nun anhand der Zeichnung der **Figur 1** näher erläutert. **Figur 1** zeigt den Singulett-Harvesting-Effekt. Der Singulett-Zustand $S_1$ wird bei dem Prozess der Elektrolumineszenz über den Singulett-Pfad (25 %) und der Triplett-Zustand $T_1$ über den Triplett-Pfad (75 %) besetzt. Nach dem sehr schnellen Prozess des Intersystem Crossing (ISC) relaxiert auch die Singulett-Anregung sehr schnell in den Triplett-Zustand $T_1$, d. h. die gesamte Anregungsenergie wird im Triplett-Zustand $T_1$ gesammelt. (Triplett-Harvesting) [1]. Bei den erfindungsgemäß zur Anwendung kommenden Metallkomplexen mit kleiner Energiedifferenz zwischen den Zuständen $T_1$ und $S_1$ wird der Zustand $S_1$ sehr effektiv thermisch gemäß $k_BT$ rückbesetzt (thermisches Gleichgewicht). Als Folge davon resultiert eine sehr kurze Abklingzeit der Emission.

**Zitierte Literatur**

[1] H. Yersin, Editor, "Highly Efficient OLEDs with Phosphorescent Materials", Wiley-VCH, Weinheim 2008.
[2] H. Yersin, Top. Curr. Chem. 2004, 241, 1.
[3] K. Walzer, B. Maennig, M. Pfeiffer, K. Leo, Chem. Rev. 2007, 107, 1233.
[4] D. R. Striplin, G. A. Crosby, J. Phys. Chem. 1995, 7977.
[5] V. M. Miskowski et al., J. Am Chem. Soc. 1978, 100, 485.

Die Erfindung wird durch die nachfolgenden Beispiele näher erläutert, ohne sie dadurch einschränken zu wollen. Der Fachmann kann, ohne erfinderisch tätig zu werden, die Erfindung im gesamten offenbarten Bereich ausführen und so weitere erfindungsgemäße organische Elektrolumineszenzvorrichtungen herstellen.

**Beispiele:**

Beispiele für zweikernige Metallkomplexe mit einem kleinen Singulett-Triplett-Abstand, in denen der Singulett-Harvesting-Effekt auftritt, sind die folgenden Komplexe:

**Beispiel 1: $[Rh_2(bridge)_4](BPh_4)_2$ (mit bridge = 1,3-Diisocyanopropan)**

Ref.: V. M. Miskowski, G. L. Nobinger, D. S. Kliger, G. S. Hammond, N. S. Lewis, K. R. Mann, H. B. Gray, J. Am. Chem. Soc. 1978, 100, 485.

**Beispiel 2: $[Rh(CO)(Cl)(dam)]_2$ (mit dam = Bis(diphenylarsino)-methan)**

Ref.: M. I. S. Kenney, J. W. Kenney III, G. A. Crosby, Organometallics 1986, 5, 230.

**Beispiel 3: $[Rh_2(CO)(Cl)(dam)_2](BPh_4)$ (mit dam = Bis(diphenyl-arsino)methan)**

Ref.: M.I. S. Kenney, J. W. Kenney III, G. A. Crosby, Inorg. Chem. 1986, 25, 1506.

**Beispiel 4: $[Rh_2(dimen)_4](PF_6)_2$ (mit dimen = 1,8-Diisocyanomethan)**

Ref.: V. M. Miskowski, S. F. Rice, H. B. Gray, R. F. Dallinger, S. J. Milder, M. G. Hill, C. L. Exstrom, K. R. Mann, Inorg. Chem. 1994, 33, 2799.

**Beispiel 5: Herstellung und Charakterisierung von organischen Elektrolumineszenzvorrichtungen**

Die Herstellung von LEDs erfolgt nach dem im Folgenden skizzierten allgemeinen Verfahren. Dieses muss

natürlich im Einzelfall auf die jeweiligen Gegebenheiten (z. B. Schichtdickenvariation, um optimale Effizienz bzw. Farbe zu erreichen) angepasst werden.

**Allgemeines Verfahren zur Herstellung der OLEDs:**

Die Herstellung solcher Bauteile lehnt sich an die Herstellung polymerer Leuchtdioden (PLEDs) an, die in der Literatur bereits vielfach beschrieben ist (z. B. in der WO 04/037887). Im vorliegenden Fall werden die erfindungsgemäßen Verbindungen zusammen mit den aufgeführten Matrixmaterialien oder Matrixmaterialkombinationen in Toluol bzw. Chlorbenzol gelöst. Der typische Feststoffgehalt solcher Lösungen liegt zwischen 10 und 25 g/L, wenn, wie hier, die für eine Device typische Schichtdicke von 80 nm mittels Spincoating erzielt werden soll.

Als Emitter- und Matrixmaterialen werden folgende Verbindungen verwendet:

| Emitter | Formel | CAS |
|---|---|---|
| E1 | $[Ir(CO)Cl(dppm)]_2$ | 99511-21-4 |
| E2 | $(Ir(CO)Cl(dam)]_2$ | 99511-22-5 |
| E3 | $[Rh(CO)Cl(dam)]_2$ | 99511-23-6 |
| E4 | $[Rh_2(CO)_2Cl(dppm)_2]BPh_4$ | 67202-35-1 |
| E5 | $[Rh_2(CO)_2Cl(dam)_2]BPh_4$ | 70561-97-6 |
| E6 | $[Rh_2(bridge)_4](BPh_4)_2$ | 61156-18-1 |
| E7 | $[Pt(dppm)(CN)_2]_2$ | 83789-83-7 |
| dam: Bis(diphenylarsino)methan, [19364-57-9]<br>bridge: 1,3-Diisocyanopropan<br>dppm: Bis(diphenylphosphino)methan | | |

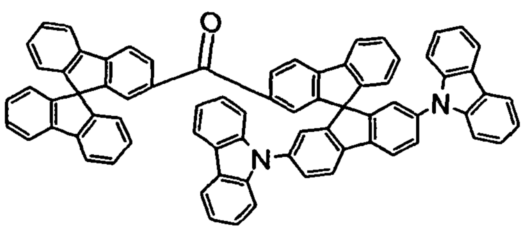

Verbindung 1
[959422-18-5]

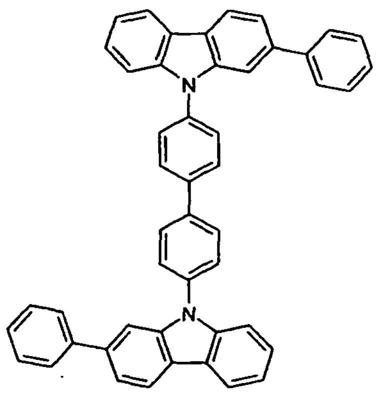

Verbindung 2
[1040882-55-0]

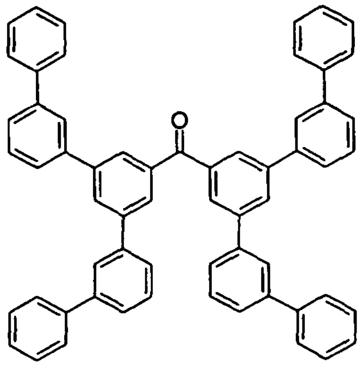

Verbindung 3
DE102008033943.1

Analog dem oben genannten allgemeinen Verfahren werden OLEDs mit folgendem Aufbau erzeugt:

| | |
|---|---|
| PEDOT | 20 nm (aus Wasser aufgeschleudert; PEDOT bezogen von BAYER AG; Poly-[3,4-ethylendioxy-2,5-thiophen] |
| Matrix + Emitter | 80 nm, 5 Gew.-% Emitterkonzentration (aus Toluol oder Chlorbenzol aufgeschleudert), |
| Ba/Ag | 10 nm Ba/150 nm Ag als Kathode. |

Strukturierte ITO-Substrate und das Material für die so genannte Pufferschicht (PEDOT, eigentlich PEDOT: PSS) sind käuflich erhältlich (ITO von Technoprint und anderen, PEDOT:PPS als wässrige Dispersion Clevios Baytron P von H.C. Starck). Die Emissionsschicht wird in einer Inertgasatmosphäre, im vorliegenden Fall Argon, aufgeschleudert und 10 min bei 120 °C ausgeheizt. Zuletzt wird eine Kathode aus Barium und Silber im Vakuum aufgedampft. Die lösungsprozessierten Devices werden standardmäßig charakterisiert, die genannten OLED-Beispiele sind noch nicht optimiert.

In Tabelle 1 sind die Effizienz uno die Spannung bei 500 cd/m$^2$ sowie die Farbe aufgeführt.

Tabelle 1

| Bsp. | Matrix Emitter | Effizienz [cd/A] | Spannung [V] | Farbe CIE x/y |
|---|---|---|---|---|
| 6 | E1<br>PVK* | 0,3 | 4,7 | 0,61 / 0,35 |
| 7 | E1<br>Verbindung 1 | 0,9 | 4,6 | 0,70 / 0,30 |
| 8 | E2<br>Verbindung 2 | 2,1 | 4,8 | 0,63 / 0,27 |
| 9 | E3<br>Verbindung 2 | 1,5 | 4,8 | 0,70 / 0,30 |
| 10 | E2<br>Verb. 2 (20 Gew.-%)<br>Verb. 3 (75 Gew.-%) | 3,1 | 4,3 | 0,63 / 0,27 |
| 11 | E4<br>Verb. 2 (40 Gew.-%)<br>Verb. 3 (55 Gew.-%) | 0,7 | 5,4 | 0,70 / 0,30 |
| 12 | E5<br>Verbindung 3 | 1,8 | 5,5 | 0,69/0,31 |
| 13 | E6<br>Verbindung 2 | 0,7 | 6,4 | 0,70/0,30 |

(fortgesetzt)

| Bsp. | Matrix Emitter | Effizienz [cd/A] | Spannung [V] | Farbe CIE x/y |
|---|---|---|---|---|
| 14 | E7<br>Verbindung 3 | 6,1 | 5,7 | 0,14/0,17 |
| *PVK: Mw = 1.100.000 g / mol bezogen von Aldrich | | | | |

## Patentansprüche

1. Organische elektronische Vorrichtung enthaltend einen Metallkomplex, der einen ΔE-Abstand zwischen dem untersten Triplett-Zustand und dem darüber liegenden Singulett-Zustand zwischen 50 $cm^{-1}$ und 3000 $cm^{-1}$ aufweist.

2. Organische elektronische Vorrichtung nach Anspruch 1, **dadurch gekennzeichnet, dass** der ΔE-Abstand zwischen 50 $cm^{-1}$ und 2000 $cm^{-1}$, bevorzugt zwischen 50 $cm^{-1}$ und 1000 $cm^{-1}$, besonders bevorzugt zwischen 50 $cm^{-1}$ und 500 $cm^{-1}$ liegt.

3. Organische elektronische Vorrichtung nach Anspruch 1 oder 2, ausgewählt aus der Gruppe bestehend aus organischen Elektrolumineszenzvorrichtungen (OLEDs), lichtemittierenden elektrochemischen Zellen (LEECs), OLED-Sensoren, insbesondere nicht hermetisch nach außen abgeschirmte Gas- und Dampf-Sensoren, organischen Solarzellen (OSCs), organischen Feldeffekttransistoren oder organischen Lasern.

4. Organische elektronische Vorrichtung nach einem oder mehreren der Ansprüche 1 bis 3, **dadurch gekennzeichnet, dass** die Metallkomplexe einkernige oder mehrkernige Metallkomplexe sind, bevorzugt mehrkernige Komplexe.

5. Organische elektronische Vorrichtung nach einem oder mehreren der Ansprüche 1 bis 4, **dadurch gekennzeichnet, dass** in den Metallkomplexen Metalle mit einer $d^8$-Elektronenkonfiguration, insbesondere Rh(I), Ir(I), Pd(II), Pt(II) und Au(III), sowie einer $d^{10}$-Elektronen-konfiguration, insbesondere Au(I), verwendet werden.

6. Organische elektronische Vorrichtung nach einem oder mehreren der Ansprüche 1 bis 5, **dadurch gekennzeichnet, dass** die Metallkomplexe die allgemeine Form **I-XV** besitzen:

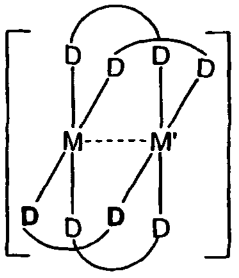

I

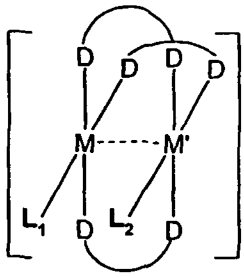

II

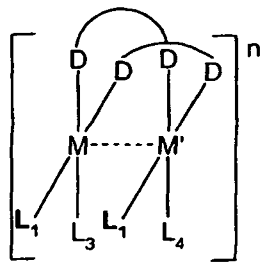

III

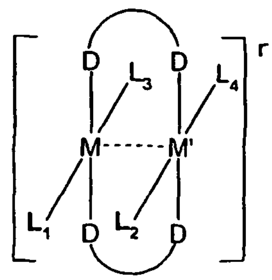

IV

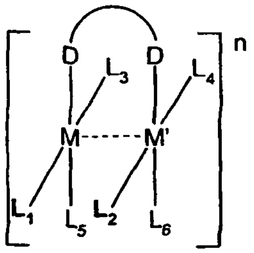

V

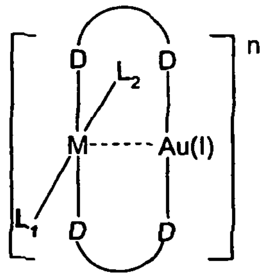

VI

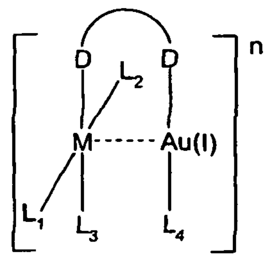

VII

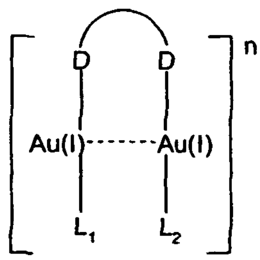

VIII

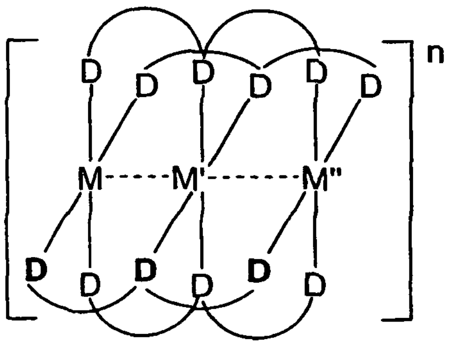

IX

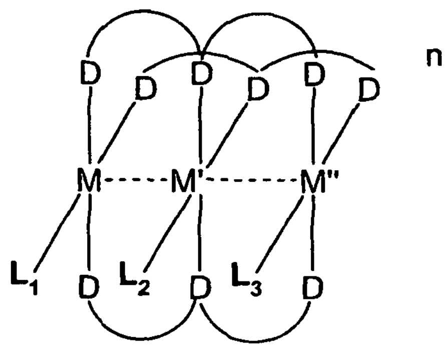

X

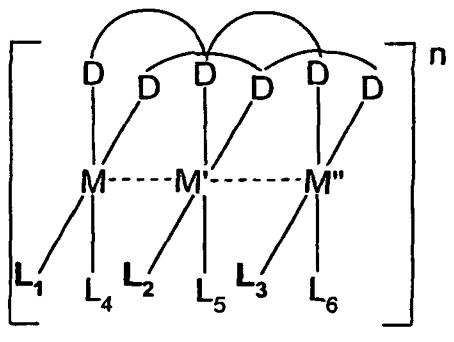

XI

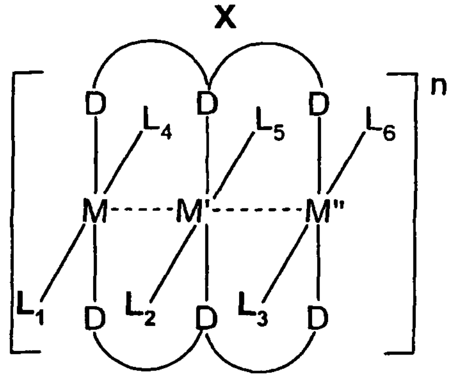

XII

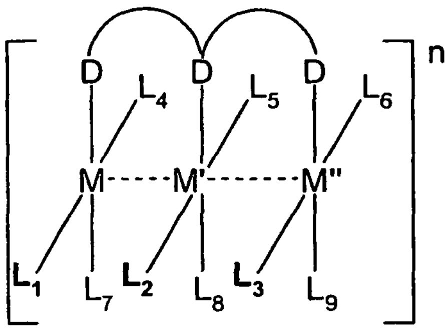

**XIII**

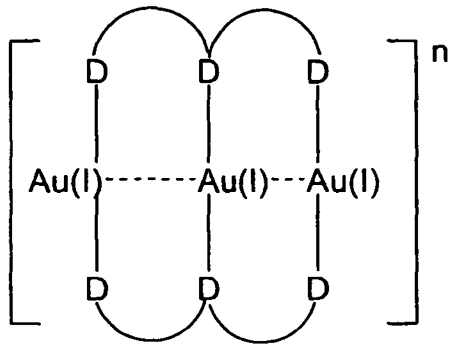

**XIV**

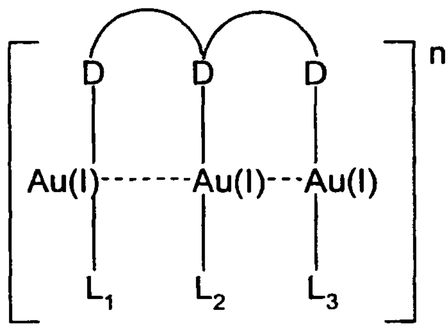

**XV**

wobei gilt:

M, M' ist gleich oder verschieden bei jedem Auftreten Rh(I), Ir(I), Pd(II), Pt(II) oder Au(III);
D∩D ist gleich oder verschieden bei jedem Auftreten ein bidentater Ligand mit den Donoratomen D;
D∩D∩D ist gleich oder verschieden bei jedem Auftreten ein tridentater Ligand mit den Donoratomen D;
$L_1$ - $L_9$ ist gleich oder verschieden bei jedem Auftreten ein monodentater Ligand
n ist die Ladung des Komplexes und ist -4, -3, -2, -1, 0, 1, 2, 3, 4, 5, 6, bevorzugt 0.

7. Organische elektronische Vorrichtung nach Anspruch 6, **dadurch gekennzeichnet, dass** in Strukturen **I** bis **VIII** M-M' gewählt ist aus:

| | | | | |
|---|---|---|---|---|
| Rh(I)-Rh(I) | Ir(I)-Ir(I) | Pd(II)-Pd(II) | Pt(II)-Pt(II) | Au(I)-Au(III) |
| Rh(I)-Ir(I) | Ir(I)-Pd(II) | Pd(II)-Pt(II) | Pt(II)-Au(I) | Au(I)-Au(I) |
| Rh(I)-Pd(II) | Ir(I)-Pt(11) | Pd(II)-Au(I) | Pt(II)-Au(III) | |
| Rh(I)-Pt(II) | Ir(I)-Au(I) | Pd(II)-Au(III) | | |
| | | Rh(I)-Au(I) | Ir(I)-Au(III) | |
| | | Rh(I)-Au(III) | | |

8. Organische elektronische Vorrichtung nach einem oder mehreren der Ansprüche 1 bis 7, **dadurch gekennzeichnet, dass** die Liganden der Metallkomplexe, die nicht überbrückend sind, insbesondere die Liganden $L_1$ bis $L_9$ ausgewählt sind aus der Gruppe bestehend aus Kohlenmonoxid, Stickstoffmonoxid, Nitrilen, Isonitrilen, Ethern, Sulfiden, Seleniden, Aminen, Iminen, Phosphinen, Phosphiten, Arsinen, Stibinen, stickstoffhaltigen Heterocyclen, Hydrid, Deuterid, F, Cl, Br, I, Azid, Alkylacetyliden, Aryl- bzw. Heteroarylacetyliden, Alkyl, Aryl, Heteroaryl, Hydroxid, Cyanid, Cyanat, Isocyanat, Thiocyanat, Isothiocyanat, aliphatischen oder aromatischen Alkoholaten, aliphatischen oder aromatischen Thioalkoholaten, Amiden, Carboxylaten, anionischen, stickstoffhaltigen Heterocyclen, aliphatischen und aromatischen Phosphiden $PR_2^-$, aliphatischen oder aromatischen Seleniden $SeR^-$, $O^{2-}$, $S^{2-}$, Nitrenen, Diaminen, Diiminen, Heterocyclen enthaltend zwei Stickstoffatome, Diphosphinen, 1,3-Diketonaten abgeleitet von 1,3-Diketonen, 3-Ketonaten abgeleitet von 3-Ketoestern, Carboxylaten abgeleitet von Aminocarbonsäuren, Salicyliminaten abgeleitet von Salicyliminen, Dialkoholaten, Dithiolaten abgeleitet von Dithiolen und Liganden , welche mit dem

Metall einen cyclometallierten Fünfring oder Sechsring mit mindestens einer Metall-Kohlenstoff-Bindung aufweisen.

9. Organische elektronische Vorrichtung nach einem oder mehreren der Ansprüche 1 bis 8, **dadurch gekennzeichnet, dass** die Donorgruppen D ausgewählt sind aus $R_2N$-, $R_2P$-, $R_2As$-, $R_2N$-, CN-, NC-, RO-, RS-, RSe-, RN=, -O-, $^-$S-,$^-$Se-,$^-$NR-,$^-CH_2$-, $^-$CH= oder $^-$C≡C-, wobei "-" oder "=" die Bindung der Gruope D an die Brücke bezeichnet, und wobei R ein Substituent ist.

10. Organische elektronische Vorrichtung nach einem oder mehreren der Ansprüche 1 bis 9, **dadurch gekennzeichnet, dass** der Ligand D∩D ausgewählt ist aus der Gruppe bestehend aus $R_2E$-$CR_2$-$ER_2$; $R_2E$-$CR_2$-$CR_2$-$ER_2$; $R_2E$-NR-$ER_2$; $R_2E$-O-$ER_2$ mit E gleich oder verschieden bei jedem Auftreten N, P oder As, Dinitrilen NC∩CN, Diisonitrilen CN∩NC, Dialkoholen HO∩OH, Diethern RO∩OR, Dithiolen HS∩SH, Dithioethern RS∩SR, Diseleniden HSe∩SeH, RSe∩SeR oder Kombinationen der Donorgruppen, wobei die Brücke ∩ bevorzugt für $(CR_2)_n$ (n = 1-6) oder aromatische Systeme steht und wobei R für einen Substituenten steht.

11. Organische elektronische Vorrichtung nach einem oder mehreren der Ansprüche 1 bis 10, wobei es sich bei der elektronischen Vorrichtung um eine organische Elektrolumineszenzvorrichtung handelt, **dadurch gekennzeichnet, dass** der Metallkomplex in der Emitterschicht eingesetzt wird, wobei der Anteil des Metallkomplexes in der Emitterschicht bevorzugt zwischen 0.1 und 50 Gew.-% beträgt.

12. Organische elektronische Vorrichtung nach einem oder mehreren der Ansprüche 1 bis 10, wobei es sich bei der elektronischen Vorrichtung um eine organische Solarzelle handelt, **dadurch gekennzeichnet, dass** der Metallkomplex in der Absorberschicht eingesetzt wird, wobei der Anteil des Metallkomplexes bevorzugt zwischen 30 und 100 Gew.-% beträgt.

13. Verwendung eines Metallkomplexes, der einen ΔE-Abstand zwischen dem untersten Triplett-Zustand und dem darüber liegenden Singulett-Zustand zwischen 50 $cm^{-1}$ und 3000 $cm^{-1}$ aufweist, in einer organischen elektronischen Vorrichtung.

14. Verwendung eines Komplexes gemäß einer der Formeln I bis XV gemäß Anspruch 6 zur Erzeugung von Licht einer bestimmten Wellenlänge.

15. Verwendung eines Metallkomplexes gemäß einer der Formeln I bis V gemäß Anspruch 6, wobei die Metallzentren M und M' gleich oder verschieden für Pt oder Pd stehen, zur Erzeugung von blauer Emission.

## Claims

1. Organic electronic device comprising a metal complex which has a ΔE separation between the lowest triplet state and the higher singlet state of between 50 $cm^{-1}$ and 3000 $cm^{-1}$.

2. Organic electronic device according to Claim 1, **characterised in that** the ΔE separation is between 50 $cm^{-1}$ and 2000 $cm^{-1}$, preferably between 50 $cm^{-1}$ and 1000 $cm^{-1}$, particularly preferably between 50 $cm^{-1}$ and 500 $cm^{-1}$.

3. Organic electronic device according to Claim 1 or 2, selected from the group consisting of organic electroluminescent devices (OLEDs), light-emitting electrochemical cells (LEECs), OLED sensors, in particular gas and vapour sensors which are not hermetically screened from the outside, organic solar cells (OSCs), organic field-effect transistors or organic lasers.

4. Organic electronic device according to one or more of Claims 1 to 3, **characterised in that** the metal complexes are mononuclear or polynuclear metal complexes, preferably polynuclear complexes.

5. Organic electronic device according to one or more of Claims 1 to 4, **characterised in that** metals having a $d^8$ electron configuration, in particular Rh(I), Ir(I), Pd(II), Pt(II) and Au(III), and a $d^{10}$ electron configuration, in particular Au(I), are used in the metal complexes.

6. Organic electronic device according to one or more of Claims 1 to 5, **characterised in that** the metal complexes have the general form **I-XV:**

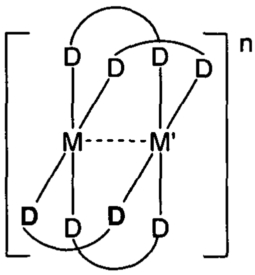 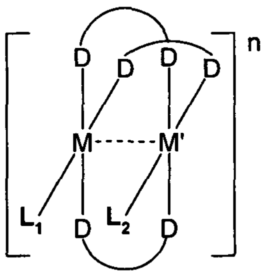 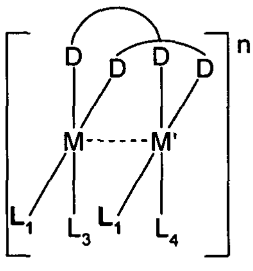 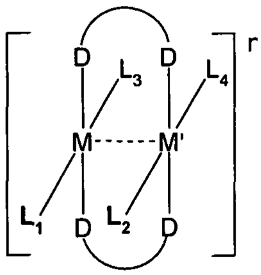

I II III IV

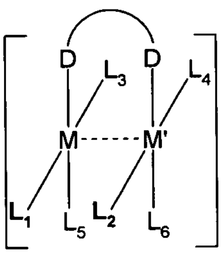

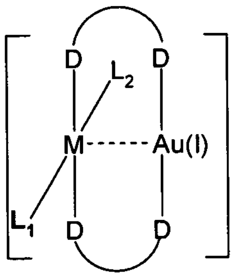

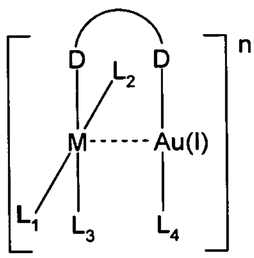

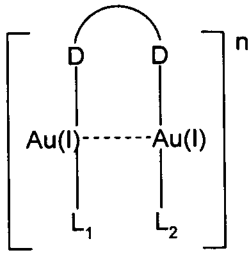

V VI VII VIII

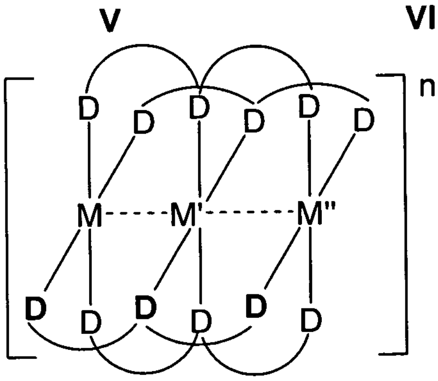

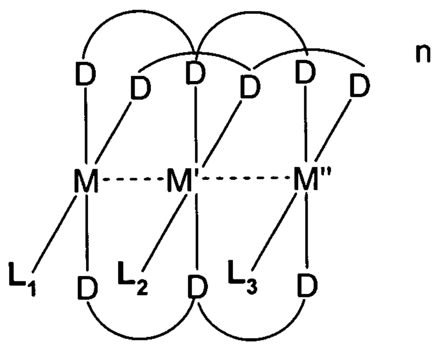

IX X

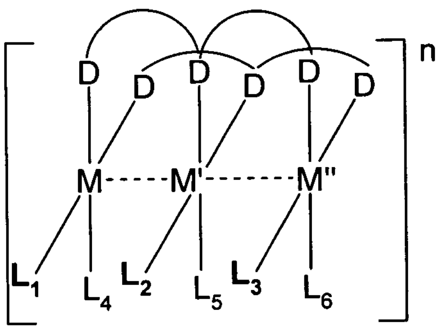

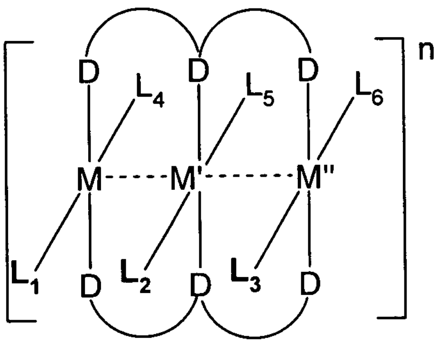

XI XII

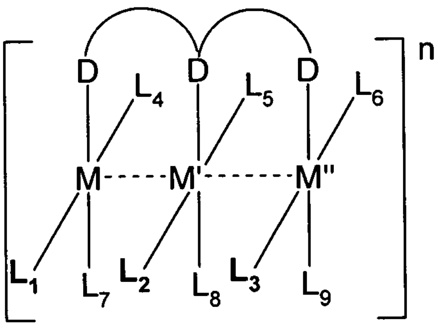

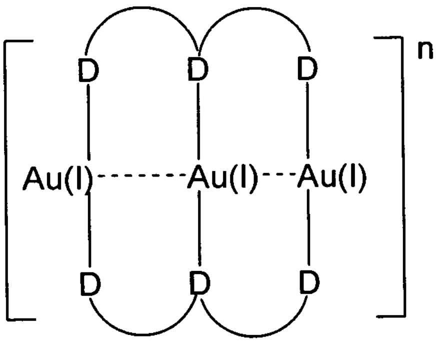

XIII XIV

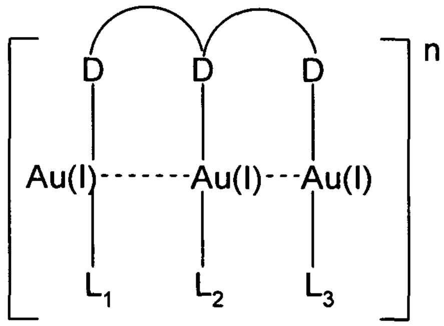

**XV**

where:

M, M' are, identically or differently on each occurrence, Rh(I), Ir(I), Pd(II), PT(II) or Au(III);
D∩D is, identically or differently on each occurrence, a bidentate ligand containing the donor atoms D;
D∩D∩D is, identically or differently on each occurrence, a tridentate ligand containing the donor atoms D;
$L_1$ - $L_9$ are, identically or differently on each occurrence, a monodentate ligand;
n is the charge of the complex and is -4, -3, -2, -1, 0, 1, 2, 3, 4, 5, 6, preferably 0.

**7.** Organic electronic device according to Claim 6, **characterised in that** M-M' in structures **I** to **VIII** is selected from:

| | | | | |
|---|---|---|---|---|
| Rh(I)-Rh(I) | Ir(I)-Ir(I) | Pd(II)-Pd(II) | Pt(II)-Pt(II) | Au(I)-Au(III) |
| Rh(I)-Ir(I) | Ir(I)-Pd(II) | Pd(II)-Pt(II) | Pt(II)-Au(I) | Au(I)-Au(I) |
| Rh(I)-Pd(II) | Ir(I)-Pt(II) | Pd(II)-Au(I) | Pt(II)-Au(III) | |
| Rh(I)-Pt(II) | Ir(I)-Au(I) | Pd(II)-Au(III) | | |
| Rh(I)-Au(I) | Ir(I)-Au(III) | | | |
| Rh(I)-Au(III) | | | | |

**8.** Organic electronic device according to one or more of Claims 1 to 7, **characterised in that** the ligands of the metal complexes which are not bridging, in particular the ligands $L_1$ to $L_9$, are selected from the group consisting of carbon monoxide, nitrogen monoxide, nitriles, isonitriles, ethers, sulfides, selenides, amines, imines, phosphines, phosphites, arsines, stibines, nitrogen-containing heterocycles, hydride, deuteride, F, Cl, Br, I, azide, alkylacetylides, aryl- or heteroarylacetylides, alkyl, aryl, heteroaryl, hydroxide, cyanide, cyanate, isocyanate, thiocyanate, isothiocyanate, aliphatic or aromatic alcoholates, aliphatic or aromatic thioalcoholates, amides, carboxylates, anionic, nitrogen-containing heterocycles, aliphatic or aromatic phosphides $PR_2^-$, aliphatic or aromatic selenides $SeR^-$, $O^{2-}$, $S^{2-}$, nitrenes, diamines, diimines, heterocycles containing two nitrogen atoms, diphosphines, 1,3-diketonates derived from 1,3-diketones, 3-ketonates derived from 3-ketoesters, carboxylates derived from aminocarboxylic acids, salicyliminates derived from salicylimines, dialcoholates, dithiolates derived from dithiols, and ligands which, with the metal, form a cyclometallated five- or six-membered ring with at least one metal-carbon bond.

**9.** Organic electronic device according to one or more of Claims 1 to 8, **characterised in that** the donor groups D are selected from $R_2N$-, $R_2P$-, $R_2As$-, $R_2N$-, CN-, NC-, RO-, RS-, RSe-, RN=, -O-, -S-, -Se-, -NR-, $-CH_2-$, -CH= or -C≡C-, where "-" or "=" denotes the bond from the group D to the bridge, and where R is a substituent.

**10.** Organic electronic device according to one or more of Claims 1 to 9, **characterised in that** the ligand D∩d is selected from the group consisting of $R_2E-CR_2-ER_2$; $R_2E-CR_2-CR_2-ER_2$; $R_2E-NR-ER_2$; $R_2E-O-ER_2$, where E is, identically or differently on each occurrence, N, P or As, dinitriles NC∩CN, diisonitriles CN∩NC, dialcohols HO∩OH, diethers RO∩OR, dithiols HS∩SH, dithioethers RS∩SR, diselenides HSe∩SeH, RSe∩SeR or combinations of the donor groups, where the bridge ∩ preferably stands for $(CR_2)_n$ (n = 1-6) or aromatic systems, and where R stands for a substituent.

**11.** Organic electronic device according to one or more of Claims 1 to 10, where the electronic device is an organic electroluminescent device, **characterised in that** the metal complex is employed in the emitter layer, where the

proportion of the metal complex in the emitter layer is preferably between 0.1 and 50% by weight.

**12.** Organic electronic device according to one or more of Claims 1 to 10, where the electronic device is an organic solar cell, **characterised in that** the metal complex is employed in the absorber layer, where the proportion of the metal complex is preferably between 30 and 100% by weight.

**13.** Use of a metal complex which has a ΔE separation between the lowest triplet state and the higher singlet state of between 50 $cm^{-1}$ and 3000 $cm^{-1}$ in an organic electronic device.

**14.** Use of a complex of one of the formulae I to XV according to Claim 6 for the generation of light of a certain wavelength.

**15.** Use of a metal complex of one of the formulae I to V according to Claim 6, where the metal centres M and M' stand, identically or differently, for Pt or Pd, for the generation of blue emission.

**Revendications**

**1.** Dispositif électronique organique comprenant un complexe métallique qui présente une séparation de ΔE entre l'état triplet le plus bas et l'état singlet plus haut d'entre 50 $cm^{-1}$ et 3000 $cm^{-1}$.

**2.** Dispositif électronique organique selon la revendication 1, **caractérisé en ce que** la séparation de ΔE est entre 50 $cm^{-1}$ et 2000 $cm^{-1}$, de préférence entre 50 $cm^{-1}$ et 1000 $cm^{-1}$, particulièrement de préférence entre 50 $cm^{-1}$ et 500 $cm^{-1}$.

**3.** Dispositif électronique organique selon la revendication 1 ou 2, choisi parmi le groupe constitué des dispositifs électroluminescents organiques (OLEDs), cellules électrochimiques émettrices de lumière (LEECs), capteurs OLED, en particulier capteurs de gaz et de vapeur qui ne sont pas protégés hermétiquement par rapport à l'extérieur, cellules solaires organiques (OSCs), transistors à effet de champ organiques ou lasers organiques.

**4.** Dispositif électronique organique selon une ou plusieurs des revendications 1 à 3, **caractérisé en ce que** les complexes métalliques sont des complexes métalliques mononucléaires ou polynucléaires, de préférence des complexes polynucléaires.

**5.** Dispositif électronique organique selon une ou plusieurs des revendications 1 à 4, **caractérisé en ce que** des métaux ayant une configuration d'électrons $d^8$, en particulier Rh(I), Ir(I), Pd(II), Pt(II) et Au(III), et une configuration d'électrons $d^{10}$, en particulier Au(I), sont utilisés dans les complexes métalliques.

**6.** Dispositif électronique organique selon une ou plusieurs des revendications 1 à 5, **caractérisé en ce que** les complexes métalliques ont la forme générale **I-XV:**

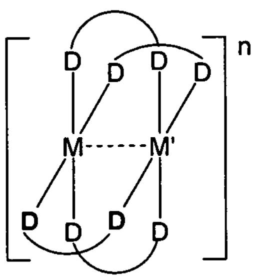

I

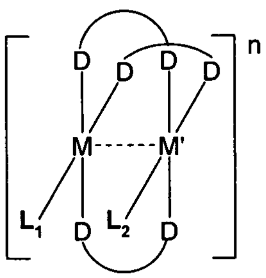

II

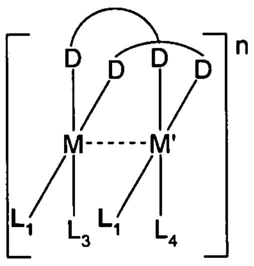

III

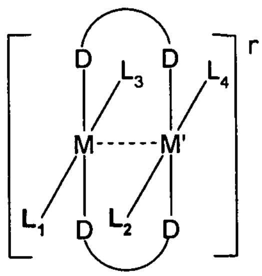

IV

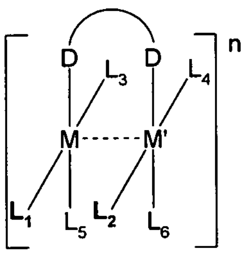

V

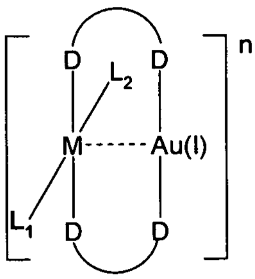

VI

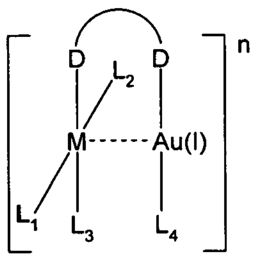

VII

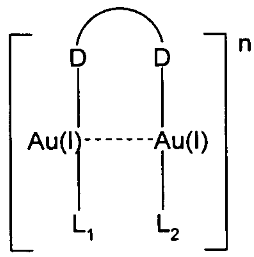

VIII

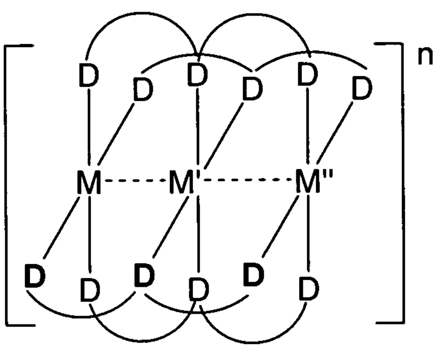

IX

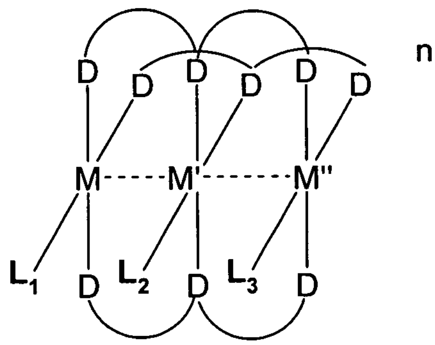

X

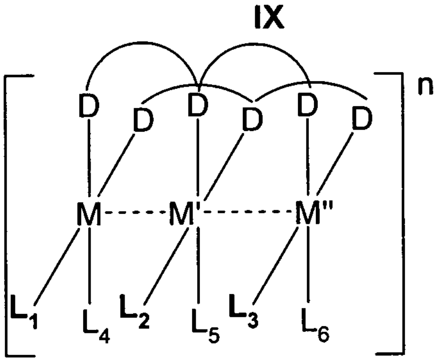

XI

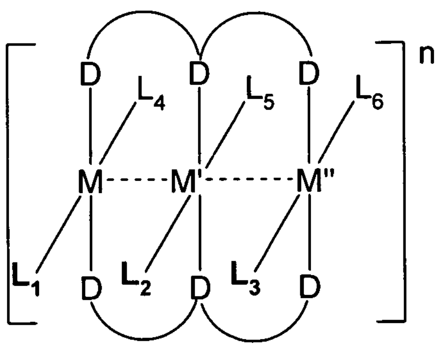

XII

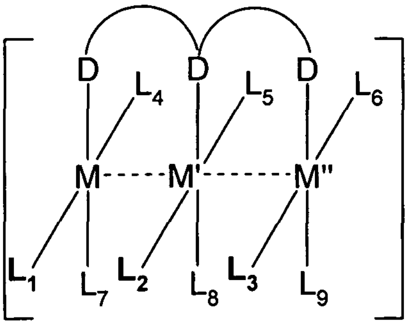

XIII

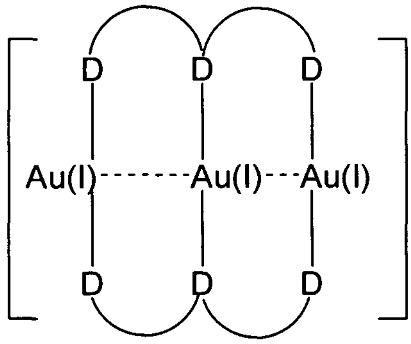

XIV

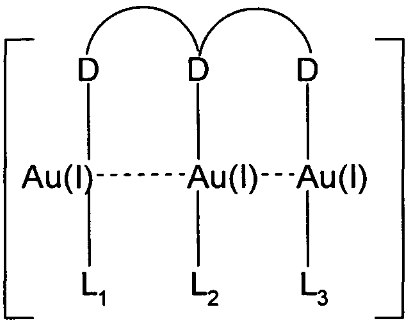

XV

dans lesquels :

M, M' sont, de façon identique ou différente à chaque occurrence, Rh(I), Ir(I), Pd(II), Pt(II) ou Au(III) ;
D∩D est, de façon identique ou différente à chaque occurrence, un ligand bidenté contenant les atomes donneurs D ;
D∩D∩D est, de façon identique ou différente à chaque occurrence, un ligand tridenté contenant les atomes donneurs D ;
$L_1$ - $L_9$ sont, de façon identique ou différente à chaque occurrence, un ligand monodenté ;
n est la charge du complexe et est -4, -3, -2, -1, 0, 1, 2, 3, 4, 5, 6, de préférence 0.

**7.** Dispositif électronique organique selon la revendication 6, **caractérisé en ce que** M-M' dans les structures **I** à **VIII** est choisi parmi :

| | | | | |
|---|---|---|---|---|
| Rh(I)-Rh(I) | Ir(I)-Ir(I) | Pd(II)-Pd(II) | Pt(II)-Pt(II) | Au(I)-Au(III) |
| Rh(I)-Ir(I) | Ir(I)-Pd(II) | Pd(II)-Pt(II) | Pt(II)-Au(I) | Au(I)-Au(I) |
| Rh(I)-Pd(II) | Ir(I)-Pt(II) | Pd(II)-Au(I) | Pt(II)-Au(III) | |
| Rh(I)-Pt(II) | Ir(I)-Au(I) | Pd(II)-Au(III) | | |
| Rh(I)-Au(I) | Ir(I)-Au(III) | | | |
| Rh(I)-Au(III) | | | | |

**8.** Dispositif électronique organique selon une ou plusieurs des revendications 1 à 7, **caractérisé en ce que** les ligands des complexes métalliques qui ne sont pas en pontage, en particulier les ligands $L_1$ à $L_9$, sont choisis parmi le groupe constitué de monoxyde de carbone, monoxyde d'azote, nitriles, isonitriles, éthers, sulfures, séléniures, amines, imines, phosphines, phosphites, arsines, stibines, hétérocycles contenant azote, hydrure, deutériure, F, Cl, Br, I, azide, alkylacétylures, aryl- ou hétéroarylacétylures, alkyle, aryle, hétéroaryle, hydroxyde, cyanure, cyanate, isocyanate, thiocyanate, isothiocyanate, alcoolates aliphatiques ou aromatiques, thioalcoolates aliphatiques ou aromatiques, amides, carboxylates, anioniques, hétérocycles contenant azote, phosphures aliphatiques ou aromatiques $PR_2^-$, séléniures aliphatiques ou aromatiques $SeR^-$, $O^{2-}$, $S^{2-}$, nitrènes, diamines, diimines, hétéroycles contenant deux atomes d'azote, diphosphines, 1,3-dicétonates dérivés de 1,3-dicétones, 3-cétonates dérivés de 3-cétoesters, carboxylates dérivés de acides aminocarboxyliques, salicyliminates dérivés de salicylimines, dialcoolates, dithiolates dérivés de dithiols, et les ligands qui, avec le métal, forment un cycle à cinq ou six éléments cyclométallatés avec au moins une liaison métal-carbone.

**9.** Dispositif électronique organique selon une ou plusieurs des revendications 1 à 8, **caractérisé en ce que** les groupes donneurs D sont choisis parmi $R_2N$-, $R_2P$-, $R_2As$-, $R_2N$-, CN-, NC-, RO-, RS-, RSe-, RN=, -O-, -S-, -Se-, -NR-, $-CH_2-$, -CH= ou -C≡C-, dans lesquels "-" ou "=" représentent la liaison depuis le groupe D jusqu'au pontage, et dans lesquels R est un substituant.

**10.** Dispositif électronique organique selon une ou plusieurs des revendications 1 à 9, **caractérisé en ce que** le ligand D∩D est choisi parmi le groupe constitué de $R_2E-CR_2-ER_2$; $R_2E-CR_2-CR_2-ER_2$; $R_2E-NR-ER_2$; $R_2E-O-ER_2$, dans lequel E est, de façon identique ou différente à chaque occurrence, N, P ou As, dinitriles NC∩CN, diisonitriles CN∩NC, dialcools HO∩OH, diéthers RO∩OR, dithiols HS∩SH, dithio-éthers RS∩SR, diséléniures HSe∩SeH, RSe∩SeR ou des combinaisons des groupes donneurs, dans lequel le pontage ∩ représente de préférence $(CR_2)_n$ (n = 1-6) ou des systèmes aromatiques, et dans lequel R représente un substituant.

**11.** Dispositif électronique organique selon une ou plusieurs des revendications 1 à 10, dans lequel le dispositif électronique est un dispositif électroluminescent organique, **caractérisé en ce que** le complexe métallique est employé dans la couche d'émetteur, dans lequel la proportion du complexe métallique dans la couche d'émetteur est de préférence entre 0,1 et 50% en poids.

**12.** Dispositif électronique organique selon une ou plusieurs des revendications 1 à 10, dans lequel le dispositif électronique est une cellule solaire organique, **caractérisé en ce que** le complexe métallique est employé dans la couche d'absorbeur, dans lequel la proportion du complexe métallique est de préférence entre 30 et 100% en poids.

**13.** Utilisation d'un complexe métallique qui présente une séparation de $\Delta E$ entre l'état triplet le plus bas et l'état singlet plus haut d'entre 50 $cm^{-1}$ et 3000 $cm^{-1}$ dans un dispositif électronique organique.

**14.** Utilisation d'un complexe de l'une des formules I à XV selon la revendication 6 pour la génération de lumière d'une certaine longueur d'onde.

**15.** Utilisation d'un complexe métallique de l'une des formules I à V selon la revendication 6, dans laquelle les centres métalliques M et M' représentent, de façon identique ou différente, Pt ou Pd, pour la génération d'émission bleue.

Figur 1

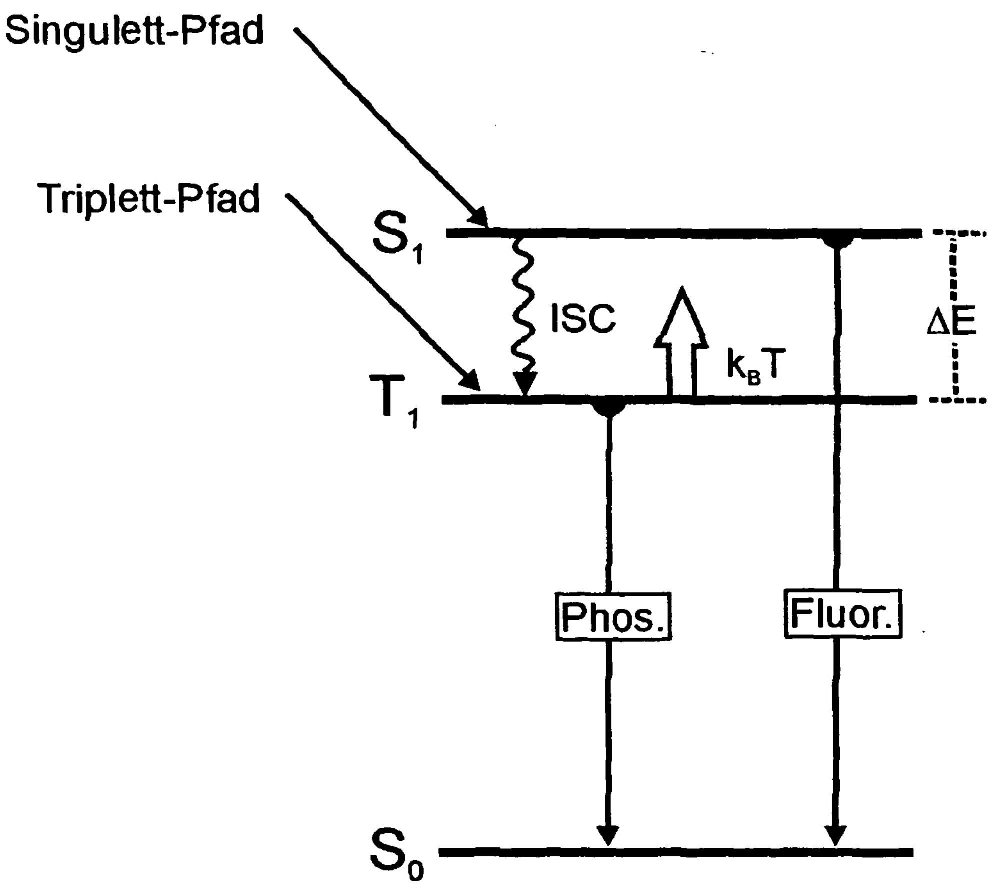

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2007031185 A
- WO 04037887 A


### In der Beschreibung aufgeführte Nicht-Patentliteratur


- Highly Efficient OLEDs with Phosphorescent Materials. Wiley-VCH, 2008
- **H. Yersin.** *Top. Curr. Chem.,* 2004, vol. 241, 1
- **K. Walzer ; B. Maennig ; M. Pfeiffer ; K. Leo.** *Chem. Rev.,* 2007, vol. 107, 1233
- **D. R. Striplin ; G. A. Crosby.** *J. Phys. Chem.,* 1995, 7977
- **V. M. Miskowski et al.** *J. Am Chem. Soc.,* 1978, vol. 100, 485
- **V. M. Miskowski ; G. L. Nobinger ; D. S. Kliger ; G. S. Hammond ; N. S. Lewis ; K. R. Mann ; H. B. Gray.** *J. Am. Chem. Soc.,* 1978, vol. 100, 485
- **M. I. S. Kenney ; J. W. Kenney III ; G. A. Crosby.** *Organometallics,* 1986, vol. 5, 230
- **M.I. S. Kenney ; J. W. Kenney III ; G. A. Crosby.** *Inorg. Chem. 1,* 1986, vol. 25, 1506
- **V. M. Miskowski ; S. F. Rice ; H. B. Gray ; R. F. Dallinger ; S. J. Milder ; M. G. Hill ; C. L. Exstrom ; K. R. Mann.** *Inorg. Chem.,* 1994, vol. 33, 2799